(19) Europäisches Patentamt
European Patent Office
Office européen des brevets

(11) **EP 2 279 863 A1**

(12) **EUROPEAN PATENT APPLICATION**
published in accordance with Art. 153(4) EPC

(43) Date of publication:
**02.02.2011 Bulletin 2011/05**

(21) Application number: **09750553.1**

(22) Date of filing: **19.05.2009**

(51) Int Cl.:
*B32B 27/30* (2006.01)   *B32B 25/14* (2006.01)
*H01L 31/04* (2006.01)

(86) International application number:
**PCT/JP2009/059168**

(87) International publication number:
**WO 2009/142191 (26.11.2009 Gazette 2009/48)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **19.05.2008   JP 2008131294**
          **19.05.2008   JP 2008131295**
          **29.01.2009   JP 2009018859**
          **29.01.2009   JP 2009018860**

(71) Applicant: **Techno Polymer Co., Ltd.**
**Minato-ku**
**Tokyo 105-0021 (JP)**

(72) Inventors:
• **WATANABE Atsushi**
**Tokyo 105-0021 (JP)**
• **HASHIMOTO Masanori**
**Tokyo 105-0021 (JP)**

(74) Representative: **Wilhelms · Kilian & Partner**
**Patentanwälte**
**Eduard-Schmid-Straße 2**
**81541 München (DE)**

(54) **LAMINATE**

(57)     This invention provides a layered product which is high in light reflectance, provided with a white color, and is small in thermal deformation and excellent in heat resistance, and further, is difficult to hydrolyze and excellent in weatherability even when used outside for a long time, difficult to crack and excellent in flexibility even in a form of film, good in processability, productivity and handleability, and prevented from curling. The layered product comprises a resin layer (B) as a base layer, a resin layer (A) layered on one side of the layer (B), and a resin layer (C) layered on the other side of the resin layer (B), wherein a thickness ($H_A$) of the resin layer (A), a thickness ($H_B$) of the resin layer (B) and a thickness ($H_C$) of the resin layer (C) satisfy the following expressions (1) and (2), and a dimensional change when left at 150°C for 30 minutes is between ±1%, and a reflectance of a light with a wavelength of 400-1400 nm is not less than 50%:

$$0.5 \leqq H_A/H_C \leqq 1.3 \quad \cdots \quad (1),$$

$$0.4 \leqq (H_A+H_C)/H_B \leqq 2.4 \quad \cdots \quad (2).$$

EP 2 279 863 A1

Fig. 1

**Description**

TECHNICAL FIELD

The present invention relates to a layered product which is high in light reflectance and excellent in heat resistance, is further excellent in weatherability, hydrolytic resistance and flexibility, is prevented from curling, and may be provided with an excellent water vapor barrier property.

BACKGROUND ART

Recently, there is a growing demand for solar cells that have been noticed as energy supplying means alternative to petroleum which is a cause of global warming. With the increase in demand for solar cells, stable supply and cost reduction of parts such as back sheets for solar cells have been required, and also there is a growing demand for improving power generation efficiency of solar cells.
Back sheets for solar cells are layered on an encapsulating resin face after encapsulating a silicon cell under the glass plate with the encapsulating resin such as ethylene vinyl acetate resin.
Conventionally, as the back sheet for solar cells, a white thermoplastic resin sheet layered on both faces of a polyester sheet has been used in order to improve reflection of sunlight so as to improve power generation efficiency of solar cells (Patent Documents 1 and 2).
However, since the back sheet for solar cells is layered on an encapsulating resin face of solar cells as mentioned above, it is required to have a water vapor barrier property in order to prevent water vapor from invading the encapsulating resin from the back sheet and deteriorating silicone cells.

CONVENTIONAL ART DOCUMENTS

PATENT DOCUMENTS

Patent Document 1: Japanese Patent Laid-open No. 2006-270025
Patent Document 2: Japanese Patent Laid-open No. 2007-177136

DISCLOSURE OF THE INVENTION

PROBLEMS TO BE SOLVED BY THE INVENTION

The present invention aims at providing a layered product which is high in light reflectance, white in color, small in thermal deformation and excellent in heat resistance, and further is difficult to hydrolyze and excellent in weatherability even when used outside for a long time, difficult to crack and excellent in flexibility even in a form of film, good in processability, productivity and handleability, and prevented from curling, and may be excellent in water vapor barrier property.

MEANS FOR SOLVING THE PROBLEM

As a result of intensive studies for solving the above problem, the present inventors have found that a layered product, which is high in light reflectance and excellent in heat resistance, is difficult to hydrolyze and excellent in weatherability even when used outside for a long time, is prevented from curling, and is excellent in flexibility, can be obtained when a white layered product having three laminated resin layers satisfies a specific dimensional change, and also satisfies a predetermined relation among the thicknesses of these layers. Thus, the present invention has been completed.
That is, the present invention, provides a layered product comprising a resin layer (B) as a base layer, a resin layer (A) layered on one side of the layer (B), and a resin layer (C) layered on the other side of the layer (B), in which a thickness ($H_A$) of the resin layer (A), a thickness ($H_B$) of the resin layer (B) and a thickness ($H_C$) of the resin layer (C) satisfy the following expressions (1) and (2), a dimensional change when left at 150°C for 30 minutes is between $\pm 1\%$, and a reflectance of a light with a wavelength of 400-1400 nm is not less than 50%:

$$0.5 \leqq H_A/H_C \leqq 1.3 \cdots (1),$$

$$0.4 \leqq (H_A + H_C)/H_B \leqq 2.4 \cdots (2).$$

Moreover, according to another preferable embodiment of the present invention, there are provided a back sheet for solar cells comprising the above layered product of the present invention, and a solar cell module.

EFFECT OF THE INVENTION

The layered product of the present invention is a white layered product which has three laminated resin layers and satisfies a specific dimensional change, and a predetermined relation among the thicknesses of these layers, and thus is high in light reflectance, excellent in heat resistance, difficult to hydrolyze and excellent in weatherability even when used outside for a long time, prevented from curling, and excellent in flexibility.
Therefore, the layered product of the present invention is suitable for use with an outdoor device which is exposed to sunlight such as a back sheet for solar cells.
The layered product of the present invention can be easily produced because all the three layers can be constituted as molded resin layers.
A layered product excellent in water vapor barrier property can be obtained by laminating a water vapor barrier layer with the layered product of the present invention.
Further, a layered product excellent in flame resistance and scratch resistance can be obtained by layering a protective layer (E) on an outer surface on a side of the layer (A) or on a side of the layer (C) of the layered product of the present invention.

BRIEF DESCRIPTION OF THE DRAWINGS

Fig. 1 is a cross sectional view showing a preferable embodiment of the back sheet for solar cells according to the present invention.
Fig. 2 is a cross sectional view showing another preferable embodiment of the back sheet for solar cells according to the present invention.
Fig. 3 is a cross sectional view showing the embodiment of the back sheet for solar cells of Fig. 1, provided with a protective layer.
Fig. 4 is a cross sectional view showing the embodiment of the back sheet for solar cells of Fig. 2, provided with a protective layer.

MODE FOR CARRYING OUT THE INVENTION

Hereinafter, the present invention is described in detail. In this specification, the term "(co)polymer" means homopolymer and copolymer, the term "(meth)acryl" means acryl and/or methacryl, and the term "(meth)acrylate" means acrylate and/or methacrylate.

Base layer of the present invention (resin layer (B))

The resin layer (B) constituting the base layer of the layered product of the present invention provides heat resistance for long term use under irradiation of light such as sunlight, and concurrently has a function of minimizing a thermal contraction even when the present layered product undergoes a dynamic temperature change history during drying or surface treatment of the layered product after printing or during another secondary process. Also, the base layer can be produced by molding a resin with a coloring agent or a resin without a coloring agent as a film or a sheet.
The thermoplastic resin (I) constituting the base layer (hereinafter, also referred to as "Component (I)") is preferably one with a low dimensional change, and concretely includes aromatic vinyl resins (for example, styrene resins, rubber-reinforced styrene resins, resin, and resins comprising (co)polymers resulting from polymerization of monomers containing aromatic vinyl compounds, such as (co)polymers of aromatic vinyl compounds), polyolefin resins (for example, polyethylene resins, polypropylene resins, ethylene-$\alpha$-olefin resins, and the like), polyvinyl chloride resins, polyvinylidene chloride resins, polyvinyl acetate resins, saturated polyester resins, polycarbonate resins, acrylic resins (for example, (co)polymers of (meth)acrylate compounds, and the like), fluorocarbon resins, ethylene/vinyl acetate resins and the like. These can be used alone or in combination of two or more.

From the viewpoint of heat resistance, the thermoplastic resin (I) has a glass transition temperature of preferably 120˚C or higher, more preferably 120-220˚C, further more preferably 130-190˚C, still furthermore preferably 140-170˚C and particularly preferably 145-160˚C. When the glass transition temperature is less than 120˚C, heat resistance is not sufficient.

When the thermoplastic resin (I) has a plurality of glass transition temperatures, the higher temperature shall be the glass transition temperature of the thermoplastic resin (I). For example, when the thermoplastic resin (I) is a resin containing a resin component and a rubber component, the thermoplastic resin (I) has a glass transition temperature of the resin component and a glass transition temperature of the rubber component, but usually since the glass transition temperature of the resin component is higher, the glass transition temperature of the resin component should be the glass transition temperature of the thermoplastic resin (I).

The thermoplastic resin (I) typically include an aromatic vinyl resin (I-1), for example, a rubber-reinforced aromatic vinyl resin (I-1-1) obtained by polymerization of a monomer (ii) comprising an aromatic vinyl compound in the presence of a rubber-like polymer (i), a (co)polymer (I-1-2) of a monomer (ii) comprising an aromatic vinyl compound, and a mixture of a rubber-reinforced aromatic vinyl resin (I-1-1) obtained by polymerization of a monomer (ii) comprising an aromatic vinyl compound in the presence of a rubber-like polymer (i) and a (co)polymer (I-1-2) of a monomer (ii) comprising an aromatic vinyl compound.

The (co)polymer (I-1-2) can be obtained by polymerization of the monomer (ii) comprising the aromatic vinyl compound in the absence of the rubber-like polymer (i). The rubber-reinforced aromatic vinyl resin (I-1-1) usually includes copolymers in which the monomer (ii) comprising the aromatic vinyl compound is graft-copolymerized onto the rubber-like polymer (i) and an engrafted component which is not grafted onto the rubber-like polymer (i) (one which is of the same type as the above (co)polymer (I-1-2)). A preferable thermoplastic resin (I) includes an aromatic vinyl resin (I-1) comprising a rubber-reinforced aromatic vinyl resin (I-1-1) obtained by polymerization of a monomer (ii) comprising an aromatic vinyl compound in the presence of a rubber-like polymer and optionally a (co)polymer (I-1-2) of a monomer (ii) comprising an aromatic vinyl compound.

The aromatic vinyl resin (I-1) of the present invention preferably contains at least one kind of the rubber-reinforced aromatic vinyl resin (I-1-1) from the viewpoint of impact resistance and flexibility, and may contain the (co)polymer (I-1-2), if required. The content of the rubber-like polymer (i) is preferably 5-40 parts by mass, more preferably 8-30 parts by mass, furthermore preferably 10-20 parts by mass, and particularly preferably 12-18 parts by mass relative to 100 parts by mass of the aromatic vinyl resin (I-1). When the content of the rubber-like polymer (i) exceeds 40 parts by mass, heat resistance is not sufficient, and processing into a film may be difficult. On the other hand, when the content of the rubber-like polymer (i) is less than 5 parts by mass, impact resistance and flexibility may be insufficient.

The aromatic vinyl resin (I-1) preferably comprises a polymer resulting from polymerization of the aromatic vinyl compound containing monomer (ii) which further contains a maleimide compound from the viewpoint of heat resistance, and usually the content of the repeating units derived from the maleimide compound is preferably 0-30 mass%, more preferably 1-30 mass%, further more preferably 5-27 mass%, still furthermore preferably 10-27 mass% and particularly preferably 15-25 mass% relative to 100 mass% of the aromatic vinyl resin (I-1). When the content of the repeating units derived from the maleimide compound is less than 1 weight%, heat resistance may be insufficient, When it exceeds 30%, flexibility of the back sheet for solar cells may be insufficient. Also, the repeating unit derived from the maleimide compound may be originated from the rubber-reinforced aromatic vinyl resin (I-1-1) or may be originated from the (co)polymer (I-1-2). The glass transition temperature of the aromatic vinyl resin (I-1) can be adjusted by the content of the repeating units derived from the maleimide compound as described later, and a (co)polymer (I-1-2) containing a repeating unit derived from a maleimide compound is advantageous for preparing an aromatic vinyl resin (I-1) having a desired glass transition temperature.

The above rubber-like polymer (i) includes but is not particularly limited to conjugated-diene rubbers such as polybutadiene, butadiene/styrene random copolymers, butadiene/styrene block copolymers and butadiene/acrylonitrile copolymers, and hydrogenated products thereof (that is, hydrogenated conjugated diene rubbers) as well as non-diene rubbers such as ethylene-$\alpha$-olefin rubbers, acrylic rubbers, silicone rubbers and silicone/acrylic composite rubbers, and these can be used alone or in combination of two or more.

Among these, ethylene-$\alpha$-olefin rubbers (i-1), hydrogenated conjugated-diene rubbers (i-2), acrylic rubbers (i-3), silicone rubbers (i-4) and silicone/acrylic composite rubbers (i-5) are preferable from the viewpoint of weatherability. Among them, acrylic rubbers (i-3), silicone rubbers (i-4) and silicone/acrylic composite rubbers (i-5) are more preferable, and silicone/acrylic composite rubbers (i-5) are particularly preferable from the viewpoint of flexibility. These can be used alone or in combination of two or more.

Examples of the ethylene-$\alpha$-olefin rubbers (i-1) include ethylene-$\alpha$-olefin copolymers and ethylene-$\alpha$-olefin-non-conjugated diene copolymers. Examples of the $\alpha$-olefin constituting the ethylene-$\alpha$-olefin rubber (i-1) include an $\alpha$-

olefin with 3-20 carbon atoms, and concretely, propylene, 1-butene., 1-pentene, 1-hexene, 4-methyl-1-pentene, 1-heptene, 1-octene, 1-decene, 1-dodecene, 1-hexadecene and 1-eicocene. These α-olefins can be used alone or in combination of two or more. The number of carbon atoms of the α-olefin is preferably 3-20, more preferably 3-12, and furthermore preferably 3-8. When the number of carbon atoms exceeds 20, copolymerizability is lowered, and surface appearance of molded articles may become insufficient. As a typical ethylene-α-olefin rubber (i-1), ethylene/propylene copolymers, ethylene/propylene/non-conjugated diene copolymers, ethylene/butane-1 copolymers and ethylene/butane-1/non-conjugated diene copolymers are included. The mass ratio of ethylene/α-olefin is preferably 5-95/95-5, more preferably 50-90/50-10, furthermore preferably 60-88/40-12 and particularly preferably 70-95/30-15. When the mass ratio of α-olefin exceeds 95, weatherability is not sufficient. On the other hand, when it is less than 5, rubber elasticity of the rubber-like polymer is not sufficient, and thus flexibility for a film may be insufficient.

The non-conjugated diene includes alkenyl norbornenes, cyclic dienes and aliphatic dienes, and preferably includes 5-ethylidene-2-norbornene and dicyclopentadiene. These non-conjugated dienes can be used alone or in combination of two or more. The ratio of the non-conjugated client is preferably 0-30 mass%, more preferably 0-20 mass% and furthermore preferably 0-10 mass% relative to the total amount of the ethylene-α-olefin rubbers (i-1). When the ratio of the non-conjugated diene exceeds 30 mass%, appearance of molded articles and weatherability may be insufficient. The amount of unsaturated groups in the ethylene-α-olefin rubber (i-1) is preferably in a range of 4-40 in terms of iodine value.

Money viscosity of the ethylene-α-olefin rubber (i-1) ($ML_{1+4}$, 100˚C; according to JIS K6300) is preferably 5-80, more preferably 10-65 and furthermore preferably 15-45. When the Mooney viscosity of the Component (i-1) exceeds 80, polymerization may become difficult, and when the Moony viscosity of the Component is less than 5, impact resistance and flexibility for a film may be insufficient.

The hydrogenated conjugated diene rubber (i-2) includes, for example, hydrogenated products of a conjugated diene block copolymer having the following structure. That is, it is a block copolymer comprising two or more of a polymer block. A made of aromatic vinyl compound units, a polymer block B in which 95 mol% or more of the double bonds of a polymer made of conjugated diene compound units with a 1,2-vinyl bond content of more than 25 mol% are hydrogenated, a polymer block C in which 95 mol% or more of the double bonds of a polymer made of conjugated diene compound units with a 1,2-vinyl bond content of not more than 25 mol% are hydrogenated, and a polymer block D in which 95 mol% or more of the double bonds of a copolymer made of aromatic vinyl compound units with conjugated diene compound units are hydrogenated.

Examples of aromatic vinyl compounds used for the production, of the above polymer block A include styrene, α-methyl styrene, methyl styrene, vinyl xylene, monochlorostyrene, dichlorostyrene, monobromostyrene, dibromostyrene, fluorostyrene, p-t-butylstyrere, ethylstyrene and vinylnaphthalene, and these can be used alone or in combination of two or more. Above all, preferable one is styrene. The ratio of a polymer block A in block copolymer is preferably 0-65 mass%, and further preferably 10-40 mass% relative to the block copolymer. When the polymer block A exceeds 65 mass%, impact resistance may be insufficient.

The above polymer blocks B, C and D can be obtained by hydrogenating a polymer of a conjugated diene compound. The conjugated diene compound used for the production of the above polymer blocks B, C and D includes, for example, 1,3-butadiene, isoprene, 1,3-pentadiene and chloroprene, but in order to obtain a hydrogenated conjugated diene rubber (i-2) which can be utilized industrially and is excellent in property, 1,3-butadiene and isoprene are preferable. These can be used alone or in combination of two or more. The aromatic vinyl compound used for the production of the above polymer block D includes the same as the aromatic vinyl compound used for the production of the above polymer block A, and these can be used alone or in combination of two or more. Above all, preferable one is styrene.

The hydrogenation ratio of the above polymer blocks B, C and D is 95 mol% or more, and preferably 96 mol% or more. When it is less than 95 mol%, gelation occurs during polymerization, and thus polymerization may not be stably performed. The 1,2-vinyl bond content of the polymer block B is preferably more than 25 mol% and not more than 90 mol%, and further preferably 30-80 mol%. When the 1,2-vinyl bond content of the polymer block B is not more than 25 mol%, rubbery properties are lost so that impact resistance may be insufficient, and when it exceeds 90 mol%, chemical resistance may be insufficient. The 1,2-vinyl bond content of the polymer block C is preferably not more than 25 mol%, and further preferably not more than 20 mol%. When the 1,2-vinyl bond content of the polymer block C exceeds 25 mol%, scratch resistance and sliding properties may not be exhibited sufficiently. The 1,2-vinyl bond content of the polymer block D is preferably 25-90 mol%, and further preferably 30-30 mol%. When the 1,2-vinyl bond content of the polymer block D is, less than 25 mol%, rubbery properties are lost so that impact resistance may be insufficient, and when it exceeds 90 mol%, chemical resistance may be obtained sufficiently. Also, the content of the aromatic vinyl compound of the polymer block D is preferably not more than 25 mass% and further preferably not more than 20 masts%. When the content of an aromatic vinyl compound of the polymer block D exceeds 25 mass%, rubbery properties are lost so that impact resistance may be insufficient.

The molecular structure of the above block copolymer may be branched, radial or in combination of these, and the block structure thereof may be diblock, triblock or multiblock or a combination of these. Examples are block copolymers represented by A-(B-A)$_n$, (A-B)$_n$, A-(B-C)$_n$, C-(B-C)$_n$, (B-C)$_n$, A-(D-A)$_n$, (A-D)$_n$, A-(D-C)$_n$, C-(D-C)$_n$, (D-C)$_n$, A-(B-C-D)$_n$, or (A-B-C-D)$_n$, (where n is an integer of not less than 1), and preferably a block copolymer having a structure of A-B-A, A-B-A-B, A-B-C, A-D-C or C-B-C.

The weight average molecular weight (Mw) of the above hydrogenated conjugated diene rubber (i-2) is preferably 10,000-1,000,000, more preferably 30,000-800,000, and further more preferably 50,000-500,000. When Mw is less than 10,000, flexibility for a film may be insufficient, and on the other hand, when it exceeds 1,000,000, polymerization may be difficult.

The acrylic rubber (i-3) is a polymer of an alkyl acrylate having an alkyl group with 2-8 carbon atoms. Concrete examples of the alkyl acrylate include ethyl acrylate, propyl acrylate, n-butyl acrylate, isobutyl acrylate, hexyl acrylate, n-octyl acrylate and 2-ethylhexyl acrylate. These can be used alone or in combination of two or more. A preferable alkyl acrylate is (n-, i)-butyl acrylate or 2-ethylhexyl acrylate. A part of the alkyl acrylate can be substituted by another copolymerizable monomer in an amount of 20 mass% at maximum. Another monomer as above includes, for example, vinylchloride, vinylidene chloride, acrylonitrile, vinylester, alkyl methacrylate, methacrylic acid, acrylic acid and styrene.

It is preferable that kinds and amounts of monomers to be copolymerized for the acrylic rubber (i-3) are selected so that it has a glass transition temperature of not more than -10°C. Also, it is preferable to appropriately copolymerize a crosslinkable monomer in the acrylic rubber, and the amount of the crosslinkable monomer to be used is usually 0-10 mass%, preferably 0.01-10 mass% and further preferably 0.1-5 mass% as a proportion relative to the acrylic rubber.

Concrete examples of the crosslinkable monomer include mono or polyethylene glycol diacrylates such as ethylene glycol diacrylate, diethylene glycol diacrylate, triethylene glycol diacrylate, tetraethylene glycol diacrylate, mono or polyethylene glycol dimethacrylates such as ethylene glycol dimethacrylate, diethylene glycol dimethacrylate, triethylene glycol dimethacrylate, tetraethylene glycol dimethacrylate, di or triallyl compounds such as divinylbenzene, diallylphthalate, diallylmaleate, diallylsuccinate and triallyltriazine, allyl compounds such as allylmethacrylate and allylacrylate, and conjugated diene compounds such as 1,3-butadiene. The above acrylic rubber is produced by known polymerization methods, and a preferable polymerization method is emulsion polymerization.

As the silicone rubber (i-4), all that are obtained by known polymerization methods can be used, and polyorganosiloxane rubber-like polymer latex obtained in a form of latex by emulsion polymerization is preferable from the viewpoint of easiness of graft polymerization.

The latex of the polyorganosiloxane rubber-like polymer can be obtained by the known method described in, for example, US patent Nos. 2,891,920 and 3,294,725 specifications. For example, a method in which an organosiloxane and water are sheared and mixed and then condensation-polymerized in the presence of a sulfonic acid emulsifier such as alkylbenzene sulfonic acid and alkylsulfonic acid using a homomixer or ultrasonic mixer. The alkylbenzene sulfonic acid is suitable because it acts as an emulsifier for the organosiloxane as well as a polymerization initiator. In this instance, it is preferable to use an alkylbenzene sulfonic acid metal salt or alkylsulfonic acid metal salt in combination, because they are effective for maintaining polymers to be stable during graft polymerization. If necessary, a grafting agent or crosslinking agent may be condensation-polymerized together to an extent that does not impair the aimed property of the present invention.

The organosiloxane to be used is, for example, one having a structural unit represented by the general formula R$_m$SiO$_{(4-m)/2}$ (wherein R is a substituted or unsubstituted monovalent hydrocarbon group, and In indicates an integer of 0 to 3), and has a linear, branched or cyclic structure, and is preferably an organosiloxane having a cyclic structure. The substituted or unsubstituted monovalent hydrocarbon group of the organosiloxane includes, for example, methyl group, ethyl group, propel group, phenyl group and these hydrocarbon groups substituted with a cyano group or the like.

Concrete examples of the organosiloxane include cyclic compounds such as hexamethylcyclotrisiloxane, octamethylcyclotetrasiloxane,
decamethylcyclopentasiloxane,
dodecamethylcyclohexasiloxane,
trimethyltriphenylcyclotrisiloxane, and a linear or branched organosiloxane. These can be used alone or in combination of two or more.

The organosiloxane may be a polyorganosiloxane that is previously condensation-polymerized to have a polystyrene-equivalent weight-average molecular weight of, for example, about 500-10,000. Also, when the organosiloxane is a polyorganosiloxane, a molecular chain terminal thereof may be blocked, for example, by hydroxyl group, alkoxy group, trimethylsilyl group, dimethylvinylsilyl group, methylphenylvinylsilyl group and methyldiphenylsilyl group.

As the grafting agent, for example, a compound having both unsaturated group and alkoxysilyl group can be used. Concrete examples of such a compound include p-vinylphenylmethyldimethoxysilane, 1-(m-vinylphenyl)methyldimethylisopropoxysilane, 2-(p-vinylphenyl)ethylmthyldimethoxysilane, 3-(p-vinylphenoxy)propylmethyldiethoxysilane, 3-(p-vinylbenzoyloxy)propylmethyldimethoxysilane, 1-(o-vinylphenyl)-1,1,2-trimethyl-2,2-dimethoxydisilane, 1-(p-vingylphenyl)-1,1-diphenyl-3-ethyl-3,3-diethoxydisiloxane, m-vinylphenyl-[3-(triethoxysilyl) propyl] diphenylsilane, [3-(p-isopropenylbenzoylamino)propy]phenyldipropoxysilane, 2-(m-vinylphenyl)ethylmethyldimethoxysilane, 2-(o-vinylphenyl)ethylmethyldimethoxysilane, 1-(p-vinylphenyl)ethylmethyldimethoxysilane, 1-(m-vinylphenyl)ethylmethyldimethoxysilane, 1-(o-vinylphenyl)ethylmethyldimethoxysilane, and a mixture of these. Of these, p-vinylphenylmethyldimethoxysilane, 2-(p-vinylphenyl)ethylmethyldimethoxysilane, and 3-(p-vinylbenzoyloxy)propylmethyldimethoxysilane are preferable, and p-vinylphenylmethyldimethoxysilane is further preferable.

The ratio of the grafting agent to be used is usually 0-10 parts by mass, preferably 0.2-10 parts by mass and further preferably 0.5-5 parts by mass relative to 100 parts by mass of the total amount of the organosiloxane, grafting agent and crosslinking agent. When the amount of the grafting agent to be used is too much, the molecular weight of the grafted vinyl polymer is lowered, and as a result, sufficient impact resistant cannot be obtained. In addition, oxidative degradation easily proceeds at double bonds of the grafted polyorganosiloxane rubber-like polymer, and thus a graft copolymer with good weatherability cannot be obtained.

An average particle diameter of particles of the polyorganosiloxane rubber-like polymer latex is usually not more than 0.5 $\mu$m, preferably not more than 0.4 $\mu$m, and further preferably 0.05-0.4 $\mu$m. The average particle diameter can be easily controlled by amounts of the emulsifier and water, a degree of dispersion upon mixing with the homomixer or ultrasonic mixer, or a way of charging the organosiloxane. When the average particle diameter of latex particles exceeds 0.5 $\mu$m, gloss is inferior.

The polystyrene-equivalent weight-average molecular weight of the polyorganosiloxane rubber-like polymer obtained as above is usually 30,00.0-1,000,000, and preferably 50,000-300,000. When the weight, average molecular weight is less than 30,000, flexibility for a film cannot be obtained sufficient. On the other hand, when the weight-average molecular weight exceeds 1,000,000, entanglement within rubber polymer chains becomes strong, and rubber elasticity is lowered, and thus flexibility for a film is lowered, or graft particles are hardly melted, and film appearance may be impaired.

The weight-average molecular weight can be easily controlled by changing temperature and time of condensation polymerization during preparation of polyorganosiloxane rubber-like polymers. That is, the lower the temperature of condensation polymerization is and/or the longer the cooling time is, the higher the molecular weight of the polymer is. Also, the polymer can be made high in molecular weight by adding a small amount of a crosslinking agent.

Meanwhile, the molecular chain terminal of the polyorganosiloxane rubber-like polymer may be blocked, for example, by hydroxy group, alkoxy group, trimethylsilyl group, dimethylvinylsilyl group, methylphenylvinylsilyl group or methyldiphenylsilyl group.

The amount of the emulsifier to be used is usually 0.1-5 parts by mass and preferably 0.3-3 parts by mass relative to 100 parts by mass of the total of the organosiloxane, grafting agent and crosslinking agent. The amount of water to be used in this instance is usually 100-500 parts by mass and preferably 200-400 parts by mass relative to 100 parts by mass of the total of the organosiloxane, grafting agent and crosslinking agent. The condensation polymerization temperature is usually 5-100°C.

During production of the polyorganosiloxane rubber-like polymer, a crosslinking agent can be added as the third component in order to improve impact resistance of the resulting graft copolymer. The crosslinking agent includes, for example, trifunctional crosslinking agents such as methyl trimethoxysilane, phenyl trimethoxysilane and ethyl triethoxysilane, and tetrafunctional crosslinking agents such as tetraethoxysilane. These can be used in combination of two or more. As these crosslinking agents, crosslinked pre-polymers that are previously condensation-polymerized can be used. The addition amount of the crosslinking agent is usually not more than 10 parts by mass, preferably not more than 5 parts by mass and further more preferably 0.01-5 parts by mass relative to 100 parts by mass of the total amount of the organosiloxane, grafting agent and crosslinking agent. When the addition amount of the above crosslinking agent exceeds 10 parts by mass, flexibility of polyorganosiloxane rubber-like polymers may be impaired so that for a film may be lowered.

The silicone/acrylic composite rubber (i-5) means a rubber-like polymer comprising a polyorganosiloxane rubber and a polyalkyl(meth)acrylate rubber. A preferable silicone/acrylic composite rubber (i-5) is a composite rubber having a structure in which a polyorganosiloxane rubber and a poly-alkyl (meth) acrylate rubber are entangled with each other so as to be inseparable.

The polyalkyl(meth)acrylate rubber includes, for example, one which can be obtained by copolymerizing an alkyl (meth)acrylate (monomer) such as methyl acrylate, ethyl acrylate, n-propyl acrylate, n-butyl acrylate, 2-ethylhexyl acrylate, ethoxyethoxyethyl acrylate, methoxy tripropylene glycol acrylate, 4-hydroxybutyl acrylate, lauryl methacrylate and stearyl methacrylate. These alkyl (meth)acrylates can be used alone or in combination of two or more.

The alkyl (meth) acrylate monomer may further comprise various vinyl monomers including aromatic vinyl compounds such has styrene, $\alpha$-methyl styrene and vinyl toluene; vinyl cyanide compounds such as acrylonitrile and methacrylonitrile; silicones modified with methacrylic acids; and fluorine-containing vinyl compounds in a range of not more than 30 mass% as comonomers.

The above polyalkyl(meth)acrylate rubber is preferably a copolymer having two or more glass transition temperatures. Such a polyalkyl(meth)acrylate rubber is preferable in order to exhibit flexibility of films.

As the above polyorganosiloxane rubber, can be used one resulting from copolymerization of an organosiloxane. The above organosiloxane includes a variety of reduced products with 3- or more membered ring, and preferably includes, for example, hexamethylcyclotrisiloxane, octamethylcyclotetrasiloxane,
decamethylcyclopentasiloxane,
dodecamethylcyclohexasiloxane,
trimethyltriphenylcyclotrisiloxane,
tetramethyltetraphinylcyclotetrasiloxane and octaphenylcyclotetrasiloxane. These organosiloxanes can be used alone or in combination of two or more. The amount of these organosiloxanes to be used is preferably not less than 50 mass%, and more preferably not less than 70 mass% relative to the polyorganosiloxane rubber components.

A silicone/acrylic composite rubber (1-5) can be produced, for example, by methods described in JP-A-H04-239010 and JP-B-2137934. As such a silicone/acrylic composite rubber graft copolymer, "METABLENE SX-006 (trade name)" manufactured by MITSUBISHI RAYON CO., LTD. is commercially available.

The monomer (ii) comprising an aromatic vinyl compound in the present invention typically includes a monomer (ii) comprising an aromatic vinyl compound alone and a monomer (ii) comprising both an aromatic vinyl compound and a vinyl cyanide compound, and is preferably one comprising both an aromatic vinyl compound and a vinyl cyanide compound.

The aromatic vinyl compounds include, for example, styrene, $\alpha$-methyl styrene, o-methyl styrene, p-methyl styrene, vinyl toluene, vinyl xylene, ethyl styrene, dimethyl styrene, p-tert-butyl styrene, vinyl naphtalene, methoxy styrene, monobromo styrene, dibromo styrene, tribromo styrene and fluorostyrene. Of these, styrene and of-methyl styrene are preferable. These aromatic vinyl compounds can be used alone or in combination of two or more.

The vinyl cyanide compounds include acrylonitrile, methacrylonitrile and $\alpha$-chloro(meth)acrylonitrile. Of these, acrylonitrile is preferable. These vinyl cyanide compounds can be used alone or in combination of two or more.

The monomer (ii) comprising an aromatic vinyl compound can further contain another compound copolymerizable with the aromatic vinyl compound or the vinyl cyanide compound. Such another compound includes (meth) acrylates, maleimide compounds, other functional group-containing unsaturated compounds (for example, unsaturated acids, epoxy group-containing unsaturated compounds, hydroxyl group-containing unsaturated compounds, oxazoline group-containing unsaturated compounds and acid anhydride group-containing unsaturated compounds). These can be used alone or in combination of two or more. The amount of such another compound to be used is preferably 0-50 mass%, more preferably 1-40 mass% and further more preferably 1-30 mass%, provided that the monomer (ii) comprising an aromatic vinyl compound is 100 mass%.

The (meth)acrylate includes, for example, methyl (meth)acrylate, ethyl (meth)acrylate, n-propyl (meth)acrylate, isopropyl (meth)acrylate, n-butyl (meth)acrylate and isobutyl (meth)acrylate. These can be used alone or in combination of two or more. Of these, methyl methacrylate is preferable.

The unsaturated acid includes, for example, acrylic acid, methacrylic acid, itaconic acid and maleic acid. These can be used alone or in combination of two or more.

The maleimide compound includes, for example, maleimide, N-methylmaleimide, N-butylmaleimide, N-phenylmaleimide and N-cyclohexylmaleimide. These can be used alone or in combination of two more. In order to Introduce a maleimide compound unit into a copolymerized resin, maleic anhydride may be first (co) polymerized, followed by imidation. Containing a maleimide compound as another copolymerizable compound is preferable from the viewpoint of improving heat resistance of the thermoplastic resin (I).

The content of the maleimide compound is usually preferably 0-30 mass%, more preferably 1-30 mass%, further more preferably 5-27 mass%, Still furthermore preferably 10-27 and particularly preferably 15-25 mass% as the repeating units derived from the maleimide compound relative to 100 mass% of the above thermoplastic resin (I). When the content of the repeating units derived from the maleimide compound is less than 1 mass%, heat resistance may be insufficient. When it exceeds 30 mass%, flexibility of a back sheet for solar cells may be insufficient.

The epoxy group-containing unsaturated compound includes, for example, glycidyl acrylate, glycidyl methacrylate and allyl glycidyl ether, and these can be used alone or in combination of two or more.

The hydroxyl group-containing unsaturated compound includes, for example, 3-hydroxy-1-propene, 4-hydroxy-1 butene, cis-4-hydroxy-2-butene, trans-4-hydroxy-2-butene, 3-hydroxy-2-ethyl-1-propene, 2-hydroxyethyl acrylate, 2-hydroxyethyl methacrylate and hydroxystyrene. These can be used alone or in combination of two or more.

The oxazoline group-containing unsaturated compound includes, for example, vinyl oxazolines. These can be used alone or in combination of two or more.

The acid anhydride group-containing unsaturated compound includes, for example, maleic anhydride, itaconic anhydride and citraconic anhydride. These can be used alone or in combination of two or more.

As the monomer (ii) comprising an aromatic vinyl compound, one which is mainly composed of an aromatic vinyl compound and a vinyl cyanide compound is preferable, and the total amount of these compounds is preferably 70-100 mass% and further preferably 80-100 mass% relative to the total amount of the monomer (ii) comprising an aromatic vinyl compound. The ratio of an aromatic vinyl compound and an vinyl cyanide compound to be used is preferably 5-95 any 5-95 mass%, more preferably 50-95 mass% and 5-50 further more preferably 60-95 mass% and 5-40 mass% and particularly preferably 65-85 mass% and 15-35 mass% respectively, provided that the total of these is 100 mass%.

According to a preferable embodiment of the present invention, as the thermoplastic resin (I), is used a rubber-reinforced aromatic vinyl resin which comprises a rubber-reinforced aromatic vinyl resin (I-1-1') obtained by polymerisation of a monomer (ii) comprising an aromatic vinyl compound in the presence of a rubber-like polymer (i) selected from the group consisting of acrylic rubbers (i-3), silicone rubbers (i-4) and silicone/acrylic composite rubbers (i-5) and optionally a (co)polymer (I-1-2') of the monomer (ii) comprising an aromatic vinyl compound. Of there, preferable are a silicone/acrylic composite rubber-reinforced styrene resin using a silicone/acrylic composite rubber (i-5) as the rubber-like polymer (i) and a mixture of a silicone rubber-reinforced styrene resin using a silicone rubber (i-4) as the rubber-like polymer (i) and an acrylic rubber-reinforced styrene resin using an acrylic rubber (i-3) as the rubber-like polymer (i), and particularly preferable is the silicone/acrylic composite rubber-reinforced styrene resin.

The rubber-reinforced aromatic vinyl resin (I-1-1) can be obtained by known polymerization methods such as emulsion polymerization, suspension polymerization, solution polymerization, bulk polymerization and polymerization methods in combination of these.

The graft ratio of the rubber-reinforced aromatic vinyl resin (I-1-1) is preferably 20-170%, more preferably 30-170% and further more preferably 40-150%. When the graft ratio is too low, flexibility for a film may bye insufficient. When the graft ratio is too high, viscosity of the thermoplastic resin becomes high so that a thin product may be difficult to make.

The graft ratio can be determined by the following equation (4).

$$\text{Graft ratio (mass\%)} = \{(S - T) / T\} \times 100 \cdots (4)$$

In the above equation, S is the mass (g) of insoluble matter obtained by adding 1 g of the rubber-reinforced aromatic vinyl resin (I-1-1) to 20 ml of acetone (but acetonitrile when an acrylic rubber is used), shaking the mixture for 2 hours by a shaker under the temperature of 25˚C, and then centrifuging the mixture by a centrifuge (at a rotation speed of 23,000 rpm) for 60 minutes under the temperature of 5˚C to separate the insoluble matter from soluble matter, and T is the mass (g) of the rubber-like polymer contained in 1 g of the rubber-reinforced aromatic vinyl resin (I-1-1). The mass of the rubber-like polymer can be obtained by a method of calculating based on polymerization prescription and polymerization conversion, a method of determining from infrared absorption spectrum (IR) , and the like.

Meanwhile, the graft ratio can be adjusted by appropriately selecting, for example, kind and amount of a chain transfer agent used in the production of the rubber-reinforced aromatic vinyl resin (I-1-1), kind and amount of a polymerisation initiator, method of addition and duration of addition of monomer components during polymerization, and polymerisation temperature.

The limiting viscosity [η] (measured at 30˚C in methyl ethyl ketone) of the soluble matter in acetone (but acetonitrile when acrylic rubber is used) of the rubber-reinforced aromatic vinyl resin (I-1-1) is preferably 0.1 to 2.5 dl/g, more preferably 0.2 to 1.5 dl/g, and further more preferably 0.25 to 1.2 dl/g. It is preferable that the limiting viscosity is within this range from the viewpoint of processability of a film and thickness accuracy of layered products.

The limiting viscosity [η] of the soluble matter in acetone (but acetonitrile when acrylic rubber is used) of the rubber-reinforced aromatic resin (I-1-1) is measured by the following method. First, the soluble matter in acetone (but acetonitrile when acrylic rubber is used) of the rubber-reinforced aromatic vinyl resin (I-1-1) is dissolved in methyl ethyl ketone to make five samples different in concentration. Then, the limiting viscosity [η] is obtained from the results of a reduced viscosity measured at each concentration at 30˚C using the Ubbelohde viscometer tube. The unit is dl/g.

The limiting viscosity [η] can be adjusted by appropriately selecting, for examples, kind and amount of a chain transfer agent used in the production of the rubber-reinforced aromatic vinyl resin (I-1-1), kind and amount of a polymerization initiator, method of addition and duration of addition of monomer components during polymerization, and polymerization temperature. Also, it can be adjusted bey appropriately selecting and blending the (co)polymers (I-1-2) different in limiting viscosity [η].

The thermoplastic resin (I) may be pelletized by previously blending required amounts of the respective components, mixing the blend in a Henschel mixer or the like, and then melt-kneading it in an extruder, or may be processed into a film or sheet by directly supplying the respective components to a film forming machine or extruding machine. In this instance, antioxidants, ultraviolet absorbents, weather resistant, agents, antiaging agents, fillers, antistatic agents, flame retardants, antifogging agents, slipping agents, antibacterial agents, fungicides, tackifiers, plasticizers, coloring agents, graphite, carbon black, carbon nanotube, and pigments (including a pigment to which functionality such as an infrared absorbing or reflecting property is imparted) can be added to the thermoplastic resin (I) in an amount which does not impair the object or the present invention.

Resin layer of the present invention (resin layer (A))

The resin component constituting the resin layer (A) is not particularly limited, and the thermoplastic resin (II) is preferable from the viewpoint of molding processability of the layered product. Also, the thermoplastic resin (II) preferably has a glass transition temperature lower than the glass transition temperature of the thermoplastic resin (I) constituting the above resin layer (B) from the viewpoint of imparting flexibility to the layered product. The thermoplastic resin (II) has a glass transition temperature of preferably 90-200˚C , more preferably 95-160˚C, further more preferably 95-150˚C and particularly preferably 110-140˚C. When the glass transition temperature of the thermoplastic resin (II) exceeds 200˚C, flexibility of the layered product tends to deteriorate, while when the glass transition temperature is less than 90˚C, heat resistance tends to be insufficient.
When the thermoplastic resin (II) has a plurality of glass transition temperatures, the higher temperature shall be the glass transition temperature of the thermoplastic resin (II). For example, when the thermoplastic resin (II) is a resin containing a resin component and a rubber component, the thermoplastic resin (II) has a glass transition temperature of the resin component and a glass transition temperature of the rubber component, but since the glass transition temperature of the resin component is usually higher, the glass transition temperature of the resin component should be the glass transition temperature of the thermoplastic resin (II).

Examples of the thermoplastic resin (II) include aromatic vinyl resins (for example, rubber-reinforced styrene resins, acrylonotrile/styrene resins, other (co)polymers of aromatic vinyl compounds, and the like), polyolefin resins (for example, polyethylene resins, polypropylene resins, ethylene-$\alpha$-olefin resins, and the like), polyvinyl chloride resins, polyvinylidene chloride resins, polyvinyl acetate resins, saturated polyester resins (for example, polyethylene terephthalate, polybutylene terephthalate, polyethylene naphthalate, polytrimethylene terephthalate, and the like), polycarbonate resins, acrylic resins (for example, (co)polymers of (meth)acrylate compounds), fluorocarbon resins, ethylene/vinyl acetate resins and the like. These can be used alone or in combination of two or more. Of these, from the viewpoint of difficulty in hydrolysis even used outside for a long time, use of an aromatic vinyl resin (II-1) is preferable.

The aromatic vinyl resin (II-1) used in the present invention (hereinafter also referred to as "Component (II-1)") is typically a rubber-reinforced aromatic vinyl resin (II-1-1) obtained by polymerization of a monomer (b) comprising an aromatic vinyl compound (that is, an aromatic vinyl compound and optionally another monomer copolymerizable with the aromatic vinyl compound) in the presence of a rubber-like polymer (a), a (co)polymer (II-1-2) of a monomer (b) comprising an aromatic vinyl compound, and a mixture of the resin (II-1-1) and the (co)polymer (II-1-2). The latter (co)polymer (II-1-2) is one which is obtained by polymerisation of a monomer (b) comprising an aromatic vinyl compound in the absence of the rubber-like polymer (a). The rubber-reinforced aromatic vinyl resin (II-1-1) usually includes copolymers in which the monomer (b) comprising an aromatic vinyl resin as graft-copolymerized onto the rubber-like polymer (a) and an ungrafted component which is not grafted onto the rubber-like polymer (a) (one which is of the same type as the above (co)polymer (II-1-2)).

The aromatic vinyl resin (II-1) of the present invention preferably contains at least one kind of the rubber-reinforced aromatic vinyl resin (II-1-1) from the viewpoint of impact resistance and flexibility, and may contain the (co)polymer (II-1-2), if required. The content of the rubber-like polymer (a) is preferably 5-40 parts by mass, more preferably 8-30 parts by mass, furthermore preferably 10-20 parts by mass, and particularly preferably 12-18 parts by mass relative to 100 parts by mass of the aromatic vinyl resin (II-1). When the content of the rubber-like polymer (a) exceeds 40 parts by mass, heat resistance is insufficient, and processing into a film may be difficult. On the other hand, when the content of the rubber-like polymer (a) is less than 5 parts by mass, flexibility may be insufficient.

As the rubber-like polymer (a), can be used one described above as the rubber-like polymer (i), and the preferable rubber-like polymer (a) is the same as the rubber-like polymer (i). However, in the layered product of the present invention, the rubber-like polymer (a) used in the aromatic vinyl resin (II-1) may be the same as or different from the rubber-like polymer (i) used in the thermoplastic resin (I).

As the monomer (b) comprising an aromatic vinyl compound, can be used one described above as the monomer (ii) comprising an aromatic vinyl compound, and the preferable monomer (b) comprising an aromatic vinyl compound is the same as the monomer (ii) comprising an aromatic vinyl compound. However, in the layered product of the present invention, the monomer (b) comprising an aromatic vinyl compound used in the aromatic vinyl resin (II-1) may be the same as or different from the monomer (ii) comprising an aromatic vinyl compound used in the thermoplastic resin (I).

The aromatic vinyl resin (II-1) preferably comprises repeating units derived from a maleimide compound from the viewpoint of heat resistance. The content of the repeating units derived from a maleimide compound is usually preferably 0-30 mass%, more preferably 1-30 mass%, furthermore preferably 5-25 mass% and particularly preferably 10-20 mass% relative to 100 mass% of the aromatic vinyl resin (II-1) . Also, the repeating unit derived from a maleimide compound may be originated from the rubber-reinforced aromatic vinyl resin (II-1-1) or may be originated from the (co)polymer (II-1-2). The glass transition temperature of the aromatic vinyl resin (II-1) can be adjusted by the content of the repeating units derived from a maleimide compound as described later, and the (co)polymer (II-1-2) containing the repeating unit derived from a maleimide compound is advantageous for preparing an aromatic vinyl resin (II-1) having a desired glass transition temperature.

According to a preferable embodiment of the present invention, as the thermoplastic resin (II), is used an aromatic vinyl resin which comprises a rubber-reinforced aromatic vinyl resin (II-1-1) obtained by polymerisation of a monomer (b) comprising an aromatic vinyl compound in the presence of a rubber-like polymer (a) selected from the group consisting of acrylic rubbers (i-3) silicone rubbers (i-4) and silicone/acrylic composite rubbers (i-5) and optionally a (co)polymer (II-1-2) of a monomer (b) comprising an aromatic vinyl compound. Of these, preferable are a silicone/ acrylic composite rubber-reinforced styrene resin using a silicone/acrylic composite rubber (i-5) as the rubber--like polymer (b), and a mixture of a silicone rubber-reinforced styrene resin using a silicone rubber (i-4) as the rubber-like polymer (b) and an acrylic rubber-reinforced styrene resin using an acrylic rubber (i-3) as the rubber-like polymer (b), and particularly preferable is the silicone/acrylic composite rubber-reinforced styrene resin.

The aromatic vinyl resin (II-1) can be obtained by known polymerization methods such as emulsion polymerization method, suspension polymerization, solution polymerization, bulk polymerization and polymerization methods in combination of these.

The graft ratio of the rubber-reinforced aromatic vinyl resin (II-1-1) is preferably 20-170%, more preferably 30-170% and furthermore preferably 40-150%. When the graft ratio is too low, flexibility for a film may be insufficient. When the graft ratio is too high, viscosity of the thermoplastic resin becomes high so that a thin product may be difficult to make.

The graft ratio can be measured by the same method as mentioned about the rubber-reinforced aromatic vinyl resin (I-1-1),

Meanwhile, the graft ratio can be adjusted by appropriately selecting, for example, kind and amount of a chain transfer anent used in the production of the rubber-reinforced aromatic vinyl resin (II-1-1), kind and amount of a polymerization initiator, method of addition and duration of addition of monomer components during polymerization, and polymerization temperature.

The limiting viscosity [η] (measured at 30°C in methyl ethyl ketone) of the soluble matter in acetone (but acetonitrile when acrylic rubber is used) of the rubber-reinforced aromatic vinyl resin (II-1-1) is preferably 0,1 to 2.5 dl/g, more preferably 0.2 to 1.5 dl/g, and furthermore preferably 0.25 to 1.2 dl/g. It is preferable that the limiting viscosity is within this range from the viewpoint of thickness accuracy of layered products.

The limiting viscosity [η] can be measured in the same manner as the rubber-reinforced aromatic vinyl resin (I-1-1).

The limiting viscosity [η] can be adjusted by appropriately selecting, for example, kind and amount of a chain transfer agent used in the production of the rubber-reinforced aromatic vinyl resin (II-1-1), kind and amount of a polymerization initiator, method of addition and duration of addition of monomer components during polymerization, and polymerization temperature. Also, it. can be adjusted by appropriately selecting and blending (co)polymers (II-1-2) different in limiting viscosity [η].

The aromatic vinyl resin (II-1) may be pelletized by previously blending required amounts of the respective components, mixing the blend in a Henschel mixer or the like, and then melt-kneading it in an extruder, or may be processed into a film or sheet by directly supplying the respective components to a film forming machine or extruding machine. In this instance, antioxidants, ultraviolet absorbents, weather resistant agents, antiaging agents, fillers, antistatic agents, flame retardants, antifogging agents, slipping agents, antibacterial agents, fungicides, tackifiers, plasticizes, coloring agents, graphite, carbon black, carbon nanotube, and the like can be added to the aromatic vinyl resin (II-1) to an extent that does not impair the object of the present invention.

Resin layer of the present invention (resin layer (C))

As the resin component constituting the resin layer (C), can be used one described above about the resin layer (A), and a thermoplastic resin (II) is preferable from the viewpoint of molding processability of layered products. Also, the thermoplastic resin (II) preferably has a lower glass transition temperature than the thermoplastic resin. (I) constituting the resin layer (B), from the viewpoint of imparting flexibility to the layered product. The glass transition temperature of the thermoplastic resin (II) is preferably 90-200°C, more preferably 95-160°C, furthermore preferably 95-150°C and particularly preferably 110-140°C. When the glass transition temperature of the thermoplastic resin (II) is higher than 200°C, flexibility of the layered product may be deteriorated, and on the other hand, when the glass transition temperature is lower than 90°C, heat resistance may tend to be insufficient. Meanwhile, all the description including description of the preferable thermoplastic resin (II) described above about the resin layer (A) is also applied to a resin component constituting the resin layer (C) as it is.

According to a preferable embodiment of the present invention, as the thermoplastic resin (II) constituting the resin layer (C), is used a rubber-reinforced styrene resin which comprises a rubber-reinforced aromatic vinyl resin (II-1-1) obtained by polymerization of a monomer (b) comprising an aromatic vinyl compound in the presence of a rubber-like polymer (a) selected from the group consisting of acrylic rubbers (i-3), silicone rubbers (i-4) and silicone/acrylic composite rubbers (i-5) and optionally a (co)polymer (II-1-2) of a monomer (b) comprising an aromatic vinyl compound. Of these, preferable are a silicone/acrylic composite rubber-reinforced styrene resin using a silicone/acrylic composite rubber (i-5) as the rubber-like polymer (b), and a mixture of a silicone rubber-reinforced styrene resin using a silicone rubber (i-4) as the rubber-like polymer (b) and an acrylic rubber-reinforced styrene resin using an acrylic rubber (i-3) as the rubber-like polymer (b) and particularly preferable is the silicone/acrylic composite rubber-reinforced styrene resin.

In the layered product of the present invention, a water vapor barrier layer (layer (D)) can be optionally layered on an outer surface of the above layer (A) or the above layer (C), or between the above layer (A) and the above layer (B) or the above layer (B) and the above layer (C).

Water vapor barrier layer of the present invention (layer (D))

The water vapor barrier layer has an effect of preventing water vapor from permeating the layered product of the present invention, and it is not particularly limited as long as it has this effect, but generally, one with a high light transmittance is preferable. The total light transmittance of the water vapor barrier layer is preferably not less than 70%, more preferably not less than 80% and furthermore preferably not less than 85%. Also, haze of the water vapor barrier layer is preferably not more than 10%, more preferably not more than 7% and furthermore preferably not more than 5%. The total light transmittance and haze are measured in accordance with JIS K 7136 or JIS K 7105. The moisture permeability of the water vapor barrier layer (also referred to as water vapor permeability) as measured under a condition at a temperature of 40˚C and humidity of 90% R.H. in accordance with JIS K 7129, is preferably 3 g/m$^2$·d or lower, more preferably 1 g/m$^2$·d or lower, and further more preferably 0.7 g/m$^2$·d or lower.

As the water vapor barrier layer, usually a thin film layer made of metals and/or metal oxides can be used. Examples of the metal include aluminum, and examples of the metal oxide include, silicone oxide and/or aluminum oxide. The thin film layer may be formed by metalplating or vapor-depositing the above metal or metal oxide to the above layer (A), (B) or (C).

In addition, the water vapor barrier layer can be formed by using a water vapor barrier film which comprises the above thin film layer which is previously vapor-deposited on a synthetic resin film. From the viewpoint of cost, it is preferable to use the water vapor barrier film which comprises the above thin film layer vapor-deposited on a synthetic resin film with a thickness of preferably about 5-50 $\mu$m and more preferably 10-15 $\mu$m. As such a resin film, generally can be used one which is molded from a synthetic resin without any coloring agent into a film or sheet, and it is preferably transparent or semi-transparent and more preferably transparent. As such a synthetic resin, generally polyethylene terephthalate (PET) film can be used. As such a water vapor barrier film, commercially available one can be used, and for example, "TECHBABRIER AX (trade name)" manufactured by MITSUBISHI PLASTICS, INC., "GX film (trade name)" manufactured by TOPPAN PRINTING CO., LTD. and "ECOSYAR VE500 (trade name)" manufactured by Toyobo Co., Ltd.

The water vapor barrier film may be layered on the outer surface of the resin layer (A) or resin layer (C) after the layered product with three layers of the resin layers (A), (B) and (C) is obtained, or may be previously layered on the resin layer (A), (B) or (C) before the layered product is obtained, or may be layered at the same time as the resin layers (A), (B) and (C). The laminating method may be a method in which lamination is performed in accordance with dry laminating method using an adhesive agent, or a method in which lamination is performed without any adhesive agent by coextrusion at the same time when at least one of the resin layers (A), (B) and (C) is molded, or at the same time when the resin layers (A), (B) and (C) are molded. As the above adhesive agent, polyurethane adhesive agents, epoxy adhesive agents and acrylic adhesive agents can be used, and of these, polyurethane adhesive agents are preferably used.

It is preferable that the layered product of the present invention shows a water vapor permeability of 3 g/m$^2$·d or lower as measured in the water vapor permeability test in accordance with JIS K 7129B at a temperature of 40˚C and humidity of 90%RH. When the water vapor permeability is higher than 3 g/m$^2$·d, durability of solar cells may be impaired.

Structure of the layered product

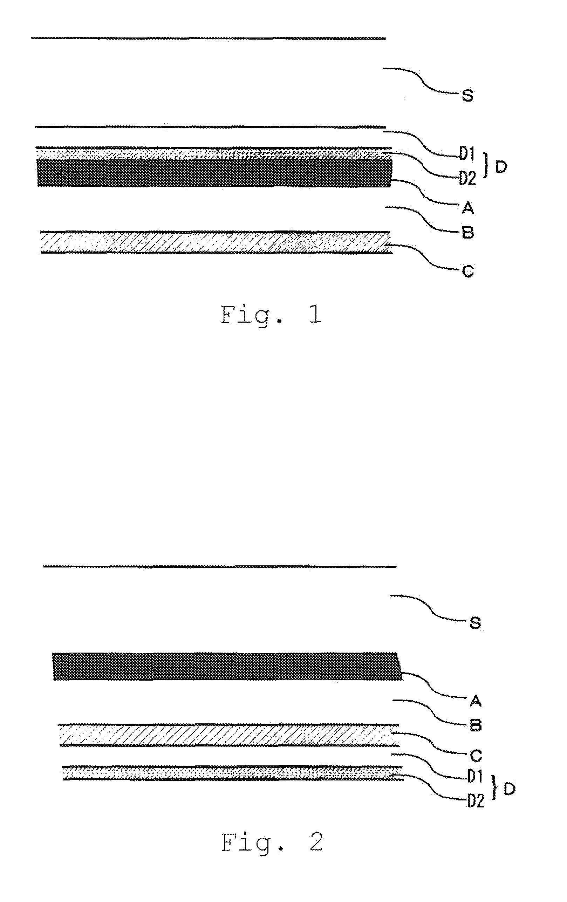

The layered product of the present invention can be produced by providing the resin layer (B) as a base layer, laminating the resin layer (A) onto one face of the resin layer (B), and laminating the resin layer (C) onto the other face. When the water vapor barrier layer is used, the layered product of the present invention has a structure in which the water vapor barrier layer (D) is arranged on the outer surface of the resin layer (A) or resin layer (C), or between the resin layer (A) and the resin layer (B) or the resin layer (B) and the resin layer (C). Of these, from the viewpoint of easiness of production, the water vapor barrier layer (D) is preferably provided on the outer surface of the resin layer (A) or the resin layer (C). As shown in Fig. 1, when a commercially available water vapor barrier film D comprising a synthetic resin film D1 and a thin film layer D2 of a metal and/or metal oxide layered thereon is used as the water vapor barrier layer (D), such a commercially available water vapor barrier film D is generally inferior in weatherability, and thus it is preferably layered on the outer surface of the resin layer (A). Since the resin layer (A) is arranged on the silicone cell S side of solar cells, the water vapor barrier layer (D) is protected by the resin layers (A) to (C), and thus this arrangement is advantageous. When the synthetic resin film D1 is made of a material inferior in hydrolytic resistance such as a polyethylene terephtalate (PET) film, it is preferable that the water vapor barrier layer (D) is layered so that the thin film layer D2 faces the resin layer (A) as shown in Fig. 1. This arrangement is advantageous in that the synthetic resin film D1 is protected by the thin film layer D2 from invasion of moisture from the outside. Meanwhile, in Fig. 1, S denotes the silicon cell for solar cells, A denotes the resin layer (A), B denotes the resin layer (B), C denotes the resin layer (C), D denotes the water vapor barrier layer (D), D1 denotes the synthetic resin film and D2 denotes the thin film layer.

The layered product of the present invention shows a dimensional change of between $\pm$ 1% when left at 150°C for 30 minutes. The layered product excellent in heat resistance can be obtained by setting the dimensional change to between $\pm$ 1%. The dimensional change when left at 150°C for 30 minutes is preferably between $\pm$ 0.8% and more preferably between $\pm$ 0.6%. In order to adjust the dimensional change of the layered product of the present invention to between $\pm$ 1%, heat resistance of the thermoplastic resin (I) used in the resin layer (B) is increased, for example. When the condition of $0.4 \leqq (H_A + H_C)/H_B \leqq 2.4$ shown in the above expression (2) is satisfied, the dimensional change of the layered product of the present invention usually corresponds to the dimensional change of such a heat-resistant resin layer (B). As a thermoplastic resin (I) constituting such a heat-resistant resin layer (B), one with a glass transition temperature of not less than 120°C is preferable.

The layered product of the present invention is a light reflective white layered product, and concretely has a reflectance of a light with a wavelength of 400-1400 nm of not less than 50%. A layered product excellent in reflectivity can be obtained by setting a reflectance of the light to not less than 50%. The reflectance of a light with a wavelength of 400-1400 nm is preferably not less than 60% and particularly preferably not less than 70%.

In the present invention, the reflectance of a light with a wavelength of 400-1400 nm of not less than 50% means that a maximum value of reflectance within a wavelength of 400-1400 nm is not less than 50%. Therefore, it does not require that the reflectance of the entire light within the wavelength of 400-1400 nm is 50% or more. Normally, when the reflectance of a light at one wavelength of the wavelength range of 400-1400 nm is not less than 50%, it is considered that the reflectance of a light with a wavelength adjacent to it is also enhanced to the same extent.

In the present invention, the reflectance of a light with a wavelength of 400-1400 nm of not less than 50% preferably means that the reflectance of the light in 30% or more of the wavelength range of 400-1400 nm is not less than 50%, and more preferably means that the reflectance of the light in 50% or more of the wavelength range of 400-1400 nm is not less than 50%. When the reflectance of a light is not less than 50% in a broader region of the wavelength range of 400 to 1400 nm, the resulting back sheet for solar cells can further improve conversion of solar cells.

In order to set the reflectance of the layered product of the present invention to not less than 50% in terms of the reflectance of a light with a wavelength of 400-1400 nm, a colored pigment high in brightness is preferably contained in at least one layer of the resin layers (A), (B) and (C) and more preferably a white pigment is contained therein. Also, it is preferable that two or more of the resin layers (A), (B) and (C) contain a colored pigment high in brightness, more preferably a white pigment. Furthermore, a colored pigment high in brightness is most preferably contained in all the resin layers (A), (B) and (C), and further preferably a white pigment is contained therein.

The L value (brightness) of the layer containing a colored pigment high in brightness is preferably not less than 55, more preferably not less than 70, furthermore preferably not less than 80 and particularly preferably not less than 95 when constructed as a layered product.

The coloring agent high in brightness is not particularly limited as long as it has a property of reflecting a light with a wavelength of 400-1400 nm, and preferably white pigments are used. Examples of the white pigment include $ZnO$, $TiO_2$, $Al_2O_3 \cdot nH_2O$, $[ZnS+BaSO_4]$, $CaSO_4 \cdot 2H_2O$, $BaSO_4$, $CaCO_3$ and $2PbCO_3 \cdot Pb(OH)_2$. These can be used alone or in combination of two or more.

The white pigment is preferably a titanium oxide.

As the titanium oxide, a titanium oxide in any crystal form such as anatase and rutile forms can be used, and the rutile form is preferable. The average primary particle diameter of the titanium oxide is preferably about 0.1-0.5 $\mu$m and more preferably about 0.15-0.35 $\mu$m. The average primary particle diameter of the titanium oxide can be measured by, for example, an image analyzer based on a transmission electron micrograph. As the titanium oxide, one with a large average primary particle diameter and one with a small average primary particle diameter can be used in combination.

The content of the pigment in the layer containing the colored pigment high in brightness is not particularly limited as long as it does not impair other properties, and is preferably an amount sufficient to allow the layered product to have a reflectance of a light with a wavelength of 400-1400 nm of not less than 50%. Concretely, it is preferably 1-40 parts by mass, more preferably 2-35 parts by mass and most preferably 3-30 parts by mass relative to 100 parts by mass of the resin components constituting the layer. When the content is less than 1 part by mass, the reflecting effect is insufficient, while when it exceeds 40 parts by mass, flexibility of the layered product is in sufficient.

According to a preferable embodiment of the layered product of the present invention in order to impart heat resistance and flexibility to the layered product, the resin layer (B) is constituted by a thermoplastic resin (I) with a glass transition temperature of not less than 120°C, and the resin layer (A) and the resin layer (C) are preferably constituted by a thermoplastic resin (II) with a glass transition temperature lower than the thermoplastic resin (I), as mentioned above. The glass transition temperature of the thermoplastic resin (I) constituting the resin layer (B) is preferably 120-220˚C. It is advantageous that the thermoplastic resin (II) constituting the resin layer (A) is the same as that of the resin layer (C). The glass transition temperature (Tg (II)) of the thermoplastic resin (II) constituting the resin layer (A) and the resin layer (C) preferably satisfy the following expression (3):

$$Tg\ (II)\ \leqq\ Tg\ (I)-10°C\ \cdots(3),$$

more preferably the following expression (3'):

$$Tg\ (I)-50˚C\ \leqq\ Tg\ (II)\ \leqq\ Tg\ (I)-10°C\ \cdots(3'),$$

and furthermore preferably the following expression (3"):

$$Tg\ (I)-30˚C\ \leqq\ Tg\ (II)\ \leqq\ Tg\ (I)-15°C\ \cdots(3'').$$

When the glass transition temperatures of the thermoplastic resin (I) and the thermoplastic resin (II) do not satisfy the expression (3), improvement of flexibility of the resulting layered product may be insufficient. When a difference between the glass transition temperature (Tg (I)) of the thermoplastic resin (I) and the glass transition temperature (Tg (II)) of the thermoplastic resin (II) exceed 50˚C, the layered product tends to be difficult to produce.

The glass transition temperatures of the thermoplastic resin (I) and the thermoplastic resin (II) can be adjusted by appropriately selecting kind or amount of the rubber-like polymer (i) or (a) to be used, or kind or amount of the monomer (ii) or (b) to be used comprising an aromatic vinyl compound, and suitably by changing an amount of the maleimide compound. Also, the glass transition temperature can be adjusted by blending an additive or filler such as a plasticizer and an inorganic filler.

In the layered product of the present invention, both of the thermoplastic resin (I) of a resin layer (B) and the thermoplastic resin (II) of a resin layer (A) and resin layer (C) are preferably resin compositions which comprise a silicone/acrylic composite rubber-reinforced styrene resin obtained by polymerization of the monomer ((ii), (a)) comprising an above aromatic vinyl monomer in the presence of the silicone/acrylic composite rubber (i-5) and contain a repeating unit derived from a maleimide compound, from the viewpoint of balance of weatherability, heat resistance, hydrolytic resistance and flexibility. In this case, from the viewpoint of balance of weatherability, heat resistance, hydrolytic resistance and flexibility, it is preferable that the silicone/acrylic composite rubber-reinforced styrene resin constituting the thermoplastic resin (I) of the resin layer (B) contains the rubber in an amount of 10-20 parts by mass relative to 100 parts by mass of the thermoplastic resin (I), and has a glass transition temperature of 150-160˚C with the content of the repeating units derived from N-phenylmaleimide being 15-30 mass% relative to 100 mass% of the thermoplastic resin (I) whilst the silicone/acrylic composite rubber-reinforced styrene resin constituting the thermoplastic resin (II) of the resin layers (A) and (C) contains the rubber in an amount of 10-20 parts by mass relative to 100 parts by mass of the aromatic vinyl resin (II-I), and has a glass transition temperature of 120-140˚C with the content of the repeating units derived from N-phenylmaleimide being 10-20 mass% relative to 100 mass%; of the aromatic vinyl resin III-1).

The layered product of the present invention may be in a form of either sheet or film. For example, when the layered product of the present invention is a film, it can be produced by methods which can be utilized for producing a film of a thermoplastic resin, including, for example, solution cast method, melt extrusion method, coextrusion method and melt press method. The melt extrusion method is excellent for a large scale production, but the solution cast method and melt press method are also useful for the purpose of a small scale or special application or quality evaluation. In the melt extrusion method, T-die or inflation method is used. In the melt press method, calendar method is used. When the layered product of the present invention is a sheet, it can be produced by methods which can be utilized for producing a thermoplastic sheet, including, for example, coextrusion method.

T-die method has an advantage of high-speed production, and in that case, the temperature of resin during molding only has to be not less than the melting temperature and lower than the decomposition temperature of the resin, and generally an appropriate temperature is 150-250˚C.

Specifications and molding conditions of molding machine for the inflation method are not limited, and conventionally known methods and conditions can be used. For example, the extruder has a caliber of 10-600 mm in diameter and a ratio L/D of 8-45 wherein D is the caliber, and L is a length L from the bottom of the hopper to the tip of cylinder. The die has a shape generally used for inflation molding, for example, has a flow geometry of a spider type, spiral type or stacking type, and has a caliber of 1-5000 mm.

As the molding machine for calendar method, for example, any of tandem-type, L-type, reversed-L-t,ype and Z-type can be used.

Further, the layered product of the present invention can be prepared, for example, by molding a single-layer film by T-die or inflation molding and then subjecting it to heat or extrusion lamination, but from the viewpoint of production cost, a multi-layer T-die extruder is preferably used for molding.

The thus-obtained layered product of the present invention has a thickness of preferably 30-500 $\mu$m, more preferably 70-450 $\mu$m, and further more preferably 80-400 $\mu$m.

When the thickness is too thin, the strength of the layered product is insufficient, and there is a risk of breaking the layered product in use. On the other hand, when the thickness is too thick, problems tend to arise such that the layered product becomes difficult to process, flexibility of the layered product is deteriorated, or whitening occurs at folded portions.

In the layered product of the present invention, a ratio ($H_A/H_C$) of a thickness ($H_A$) of the resin layer (A) to a thickness ($H_C$) of the resin layer (C) satisfies $0.5 \leqq H_A/H_C \leqq 1.3$. When the layered product satisfies this condition, it can be prevented from curling.

In the layered product of the present invention, a ratio ($H_A/H_C$) of a thickness ($H_A$) of the resin layer (A) to a thickness ($H_C$) of the resin layer (C) preferably satisfies $0.6 \leqq H_A/H_C \leqq 1.2$, and more preferably $0.7 \leqq H_A/H_C \leqq 1.1$.

In the layered product of the present invention, a ratio ($H_A+H_C$)/ $H_B$ of a total thickness of the thickness ($H_A$) of the resin layer (A) and the thickness ($H_C$) of the resin layer (C) to a thickness ($H_B$) of the resin layer (B) satisfies $0.4 \leqq (H_A+H_C)$ / $H_B \leqq 2.4$. When this condition is satisfied, the layered product excellent in balance between heat resistance and flexibility can be obtained.

In the layered product of the present invention, a ratio ($H_A+H_C$)/ $H_B$ of a total thickness of the thickness ($H_A$) of the resin layer (A) and the thickness ($H_C$) of the resin layer (C) to a thickness ($H_B$) of the resin layer (B) preferably satisfies $0,5 \leqq (H_A+H_C)$ / $H_B \leqq 2.3$.

The thickness ($H_B$) of the resin layer (B) is preferably 10-300 $\mu$m and more preferably 30-250 $\mu$m. When the resin layer (B) is too thin, heat resistance is interior, and when it is too thick, flexibility is inferior. Also, the thickness ($H_A$) of the resin layer (A) and the thickness ($H_C$) of the resin layer (C) are both preferably 10-300 $\mu$m and more preferably 30-240 $\mu$m. When the resin layers (A) and (C) are too thin, flexibility is inferior, and when they are too thick, heat resistance is inferior.

Further, for example, when the thickness of the whole layered product is 250 $\mu$m, the thicknesses of the resin layer (A) /the resin layer (B)/the resin layer (C) are preferably 30-100/50-190/30-100 $\mu$m, more preferably 40-90/70-170/40-90 $\mu$m and further more preferably 50-80/90-150/50-80 $\mu$m. When the thickness of the resin layer (A) exceeds 100 $\mu$m, heat resistance tends to be insufficient, and on the other hand, when the thickness of the resin layer (A) is less than 30 $\mu$m, flexibility of the layered product film tends to be insufficient.

In the layered product of the present invention, a protective layer (E) can be optionally layered on the outer surface of the layer (A) and/or the outer surface of the layer (C). Particularly, when the layered product of the present invention is used as a back sheet for solar cells, it is preferable that the protective layer (E) is provided on the outer surface of the layer (C) which is positioned at the side opposite to solar cells from the viewpoint of power generation efficiency and adhesion to the solar cells.

In addition, in the layered product of the present invention, for example, when the water vapor barrier layer (D) is provided on the outer surface of the layer (A), the protective layer (E) can be layered on the outer surface of the layer (C), and when the water vapor barrier layer (D) is provided on the outer surface of the layer (C), the protective layer (E) can be layered on the outer surface of the layer (D). Particularly, when the water vapor barrier (D) is provided on the outer surface of the layer (C), a vapor-deposited layer of the water vapor barrier layer (D) is positioned to be the outer surface, and thus the protective layer (E) layered thereon can function to protect the vapor-deposited layer, thereby improving durability of the water vapor barrier property. In addition, since the layer (A) is layered on solar cells, high adhesion between the layered product and solar cells can be achieved.

The protective layer (E) is frequently used in cover films and back sheets for solar cells for improving physical properties such as scratch resistance and penetration resistance, chemical properties such as chemical resistance or thermal properties such as flame resistance, and, in the present invention, is preferably one which can improve flame resistance and scratch. resistance of the back sheet for solar cells.

Such a protective layer (E) includes, for example, fluorocarbon resin films such as polyvinylfluoride film and ethylene-tetrafluoroethylene copolymer film, polycarbonate film, polyarylate film, polyethersulfone film, polysulfone film, polyacrylonitrile film, polyethylene terephthalate (PET) film, polyethylene naphthalate (PEN) film, cellulose acetate film, acrylic resin film and polypropylene film with weatherability. Of these, as the protective layer used in the present invention, fluorocarbon resin film, polyethylene terephthalate film and polyethylene naphthalate film are preferable due to excellent flame resistance and scratch resistance. Polyethylene terephtalate film and polyethylene naphthalate film are preferable because both are excellent in hydrolytic resistance. These can be used as a single film or a laminated film of two or more layers.

The thickness of the protective layer (E) is preferably 25-300 $\mu$m and more preferably 25-200 $\mu$m. When the thickness of the protective layer (E) is less than 25 $\mu$m, the effect of protecting the layered product is insufficient. When the thickness of the protective layer (E) exceeds 300 $\mu$m, flexibility of the layered product is insufficient and also the weight of the layered product is increased, and thus this is not preferable.

When the layered product of the present invention comprises the resin layer (A), the resin layer (B), the resin layer (C) and the protective layer (E) and when it comprises the resin layer (A), the resin layer (B), the resin layer (C), the water vapor barrier layer (D) and the protective layer (E), the thickness of the layered product is preferably 55-800 $\mu$m, more preferably 95-700 $\mu$m and further preferably 105-600 $\mu$m.

Further, in the layered product of the present invention, the resin layer (A) is usually used as a surface for receiving a light such as sunlight, and thus it can be provided, with a cohesive layer or adhesive layer on a surface of the resin layer (C) as the back side in order to obtain a cohesive film, adhesive film, cohesive sheet or adhesive sheet. A protective film can be further provided on a surface of the cohesive layer or adhesive layer so as to protect these layers.

If required, another layer may be layered between the resin layer (B) and the resin (A) or the resin layer (C) of the layered product, which includes a decorative layer, and a layer made of a recycle resin (usually, the thermoplastic resin (I), the thermoplastic resin (II) and a blend of these ingredients) generated during production, as long as the effect of the present invention is not impaired.

The layered product of the present invention is suitably used as a back sheet for solar cells, especially a back sheet for solar cells of crystalline silicon type, as well as others including interior materials for automobiles, building materials, and colored reflective plates for infrared heaters.

A solar cell module using the layered product of the present, invention as the back sheet for solar cells is usually composed of a transparent substrate such as glass, a sealing film, a solar cell element, a sealing film and the back sheet for solar cells of the present invention in this order from the sunlight receiving surface side.

As the transparent substrate, generally glass is used. Since glass is excellent in transparency and weatherability but low in impact resistance and heavy, a transparent resin with weatherability is also preferably used for the solar cells placed on the roof of ordinary houses. The transparent resin includes a fluorocarbon resin film. The thickness of the transparent substrate is usually 3-5 mm when glass is used, and usually 0.2-0.6 mm when a transparent resin is used.

As the sealing film, an olefin resin is used. Here, the olefin resin collectively refers to polymers resulting from polymerization or copolymerization of an olefin such as ethylene, propylene, butadiene and isoprene or a diolefin, and includes copolymers of ethylene with another monomer such as vinyl acetate and acrylic acid esters and ionomers thereof. Concretely, it includes polyethylene, polypropylene, polymethylpentene, ethylene/vinyl chloride copolymer, ethylene/vinylacetate copolymer (EVA), ethylene/vinyl alcohol copolymer, chlorinated polyethylene and chlorinated polypropylene, and of these, EVA is widely used. EVA may be painted as a cohesive agent or adhesive agent or used in a sheet form, but generally is used in a sheet form which is heat-pressed. When it is used in a sheet form, the thickness thereof is usually 0.2-5.0 nm.

As the solar cell element, a known silicon can be used. The silicon may be amorphous silicon, monocrystalline silicon or polycrystalline silicon. Comparing a response bandwidth of solar spectrum of amorphous silicon and polycrystalline silicon, a response bandwidth of amorphous silicone is present in a visible light side, while a response bandwidth of polycrystalline silicone is present in an infrared side. Distribution of solar energy is about 3% in ultraviolet region, about 47% in visible light region, and about 50% in infrared region. The use of the back sheet for solar cells of the present invention excellent in reflective property in combination with the solar cell element can provide a solar cell module excellent in the power generation efficiency, and also excellent in heat resistance, weatherability, hydrolytic resistance and flexibility.

The above structural units or the solar cell module can be bonded together using an adhesive agent. As the adhesive agent, known adhesive agents can be used, for example, butyl rubber adhesive agents, silicone adhesive agents and EPDM adhesive agents are included.

EXAMPLE

Hereinafter, the present invention will be described in more detail by way of Examples. However, the preset invention is in no way restricted to the following Examples. The units "parts" and "%" in Examples and Comparative Examples are on mass basis unless otherwise specified.

1. Evaluation method

The measurement methods for various evaluation items in the following Examples and Comparative Examples are shown below.

1-1. Rubber content of thermoplastic resins (I) and (II)

It was calculated from a composition of charged raw materials.

1-2. Content of N-phenylmaleimide unit

It was calculated from a composition of charged raw materials.

1-3. Glass transition temperature (Tg)

It was measured using differential scanning calorimeter of type DSC2910 (trade name; manufactured by TA Instruments) in accordance with JIS K 7121.

1-4. Reflectance (%) of a light with a wavelength of 400-1400 nm of the layered product

It was measured using a test piece (50 mm X 50 mm) of the layered product with V-670 manufactured by JASCO Corporation. Range of wavelength was 200-2700 nm. Reflectance in a range of wavelength of 400-1400 nm was measured. Meanwhile, in Comparative Example 2, measurement was made in the same manner as above, except that a mono-layered product was used instead of the resulting layered product.

1-5. L value

A test piece (50 mm X 50 mm X 100 $\mu$) of the layered product was used, and L value of the surface on the side of the resin layer (A) thereof was measured with an absorption spectrophotometer TCS-II manufactured by Toyo Seiki Seisaku-sho, Ltd. Meanwhile, in Comparative Example 2, measurement was made in the same manner as above, except that a mono-layered product was used instead of the resulting layered product.

1-6. Dimensional change (%) of a layered product or a layer (B) alone after heating at 150˚C for 30 min. (heat resistance)

A square of 50 mm (MD: extruding direction of a resin from T-die) x 50 mm (TD: vertical direction to MD) was drawn on the center of a surface of a test piece of 100 mm (MD) X 100 mm (TD), and the test piece was heated and left at 150˚C for 30 minutes in a thermostatic chamber, and then taken out to measure a dimensional change in MD and TD directions of the test piece. The after heating was taken as an average of the measured values of length in MD and TD directions of the above square. The shrinkage was determined based on the following equation from the measured dimensions before and after heating.
$$\text{Shrinkage (\%)} = \frac{(\text{Length after heating}) - (\text{Length before heating})}{(\text{Length before heating})} \times 100$$

1-7. Flexibility (bending test)

A test piece of 100 mm (MD) X 100 mm (TD) was cut out from a layered product, bended along an axis of symmetry in MD direction, and then along an axis of symmetry in TD direction. A manual pressing roll (2000 g) was used to make two round trips on each crease of the bended test piece at a speed of 5 mm/sec in accordance with JIS Z0237. Then, the crease was unfolded to return to an original condition, and the condition of the test piece was visually observed. Criteria are shown below. In the test results, one having no crack of crease is excellent in flexibility. Meanwhile, in Comparative Example 2, measurement was made in the same manner as above, except that a mono-layered product was used instead of the resulting layered product.
◎: No crease was cracked, and further bending and unfolding did not cause the crease to crack.
○: No crease was cracked, but further bending and unfolding caused the crease to crack.
✕: A crease was cracked.

1-8. Hydrolytic resistance (pressure cooker test)

1-8-1, Retention of fracture stress

A test piece of 150 mm (MD) X 15 mm (TD) was cut out from a layered product, and left under the condition with a temperature of 12C°C and a humidity of 100% for 100 or 200 hours, and then fracture stress of the test piece was measured in accordance with JIS K 7127 using an AG2000 tensile testing machine (manufactured by SHIMADZU CORPORATION). A distance between chucks at the time of sample setting was 100 rum and tensile rate was 300 mm/min. From the resulting measured values of fracture stress, retention of fracture stress was determined by the following equation. Meanwhile, in Comparative Example 2, measurement was made in the same manner as above, except that a mono-layered product was used instead of the resulting layered product.
$$\text{Retention of fracture stress (\%)} = \frac{\text{Fracture stress of test piece after leaving}}{\text{Fracture stress of test piece before leaving}} \times 100$$

Hydrolytic resistance was evaluated based on the obtained retention of fracture stress according to the following criteria. The higher the retention is, the better the hydrolytic resistance is.
○: retention of fracture stress exceeds 30%.
△: retention of fracture stress is 50-80%.
×: retention of fracture stress is less than 50%.

1-8-2. Retention of elongation

Fracture elongation was measured simultaneously with the measurement of the above 1-8-1. Retention of elongation was determined by the following equation from the resulting measured value of elongation.
$$\text{Retention of elongation (\%)} = \frac{\text{Fracture elongation of test piece after leaving}}{\text{Fracture elongation of test piece before leaving}} \times 100$$

Hydrolytic resistance was evaluated based on the obtained retention of elongation according to the following criteria. The higher the retention is, the better the hydrolytic resistance is.

○: retention of elongation exceeds 80%.
△: retention of elongation is 50-80%
× retention of elongation is less than 50%

1-8-3. Measurement of curl (deformation)

A test piece of 150 mm (MD) X 15 mm (TD) was cut out from a layered product, and was left under the condition with a temperature of 120°C and a humidity of 100% for 100 or 200 hours, and then curl (deformation) of the test piece was visually observed and evaluated according to the following criteria. Meanwhile, in Comparative Example 2, measurement was made in the same manner as above, except that a mono-layered product was used instead of the resulting layered product.

○: no curl (deformation).
×: there is curl (deformation).

## 1-9. Improvement rate of conversion efficiency

In a chamber which was conditioned at a temperature of 25°C±2°C and humidity of 50±5%RH, a 1/4 polycrystalline silicone cell which had been previously measured for its conversion efficiency was provided on the front side thereof with a glass having a thickness of 3 mm and on the back side thereof with a layered product, and then encapsulated in EVA to prepare a module, and measured for conversion efficiency using a solar simulator PEC-11 manufactured by Peccell. Meanwhile, in order to lower the effect of temperature, conversion efficiency was measured immediately after irradiation with light. Improvement rate of conversion efficiency was determined by the next equation. The higher the improvement rate of the above conversion efficiency is, the higher the power generation efficiency of solar cells is. Meanwhile, in Comparative Example 2, measurement was made in the same manner as above, except that a mono-layered product was used instead of the resulting layered product.

$$\text{Improvement rate of conversion efficiency (\%)} = \frac{(\text{conversion efficiency of module}) - (\text{conversion efficiency of cell alone})}{\text{conversion efficiency of cell alone}} \times 100$$

## 1-10. Weatherability

Metaling Weather Meter MV3000 (manufactured by Suga Test Instruments Co., Ltd.) was used to perform an exposure test for a test piece of 50 mm (MD) X 30 mm (TD) which was cut out from a layered product, by repeating conditions of steps 1-4 shown below, and a color change value ΔE between before exposure and 100 hours after exposure was calculated,
Meanwhile, in Comparative Example 2, measurement was made in the same manner as above, except that a mono-layered product was used instead of the resulting layered product.

Step 1: irradiation 0.53 KW/m$^2$, 63°C, 50%RH, 4 h
Step 2: irradiation+raining 0.53 kw/m$^2$, 63°C, 95%RH, min
Step 3: darkness 0 KW/m$^2$, 30°C, 98%RH, 4 h
Step 4: irradiation+raining 0.53 KW/m$^2$, 63°C, 95%RH, 1 min

Lab (L: brightness, a: redness, b: yellowness) was measured using Spectrophotometer V670 (manufactured by JASCO Corporation), and ΔE was calculated by the next equation.

$$\Delta E = \sqrt{[(L_1 - L_2)^2 + (a_1 - a_2)^2 + (b_1 - b_2)^2]}$$

wherein, $L_1$, $a_1$ and $b_1$ indicate values before exposure, and $L_2$, $a_2$ and $b_2$ indicate values after exposure. The smaller the ΔE value is, the smaller the color change is and the better the weatherability is. Evaluation standards are shown, as follows.

○: ΔE is not more than 10.
×: ΔE exceeds 10.

## 1-11. Water vapor barrier property (water vapour permeability test)

It was measured in accordance with JIS K 7129B under the following conditions.

Test device: PERMATRAN W3/31 (manufactured by MOCON) Test temperature: 40°C
Test humidity: 90%RH (practically measured humidity) Permeation face: the layer (C) side of the layered product was arranged on water vapor side.

1-12. Flame resistance

Using a burner for UL94 V-test, a lower end of a test piece (width: 20 mm x Length: 100 mm) suspended with shorter side at the top was fired for 5 seconds under the condition that the test piece was 10 mm away from the tip of the burner. After the completion of firing, a combustion condition of the fired part of the test piece was visually observed, and evaluated under the following standards.

○: there is no burning
×: there is burning

1-13. Scratch resistance

Using a reciprocating friction tester manufactured by Tosoku Seimitsu Kogyo Kabnshiki-Kaisha, a surface of a test piece was rubbed 500 times by reciprocation with a cotton canvas cloth No. 3 under a vertical load of 500 g, and then the surface was visually observed and evaluated under the following standards.

○: no scratch is observed.
△: a little scratch is observed.
×: scratch is observed clearly.

2, Method for producing a layered product

2-1. Materials to be used

2-1-1. Butadiene rubber-reinforced styrene resin

(Preparation of butadiene graft copolymer (a))

In a glass reaction vessel equipped with a stirrer, 75 parts of ion-exchanged water, 0.5 part of potassium rosinate, 0.1 part of t-dodecylmercaptane, 32 parts (as solid matter) of polybutadiene latex (average particle diameter: 270 nm, gel content: 90%), 8 parts of styrenebutadiene copolymer latex (styrene content: 25%, average particle diameter: 550 nm), 15 parts of styrene and 5 parts of acrylonitrile were placed, and the mixture was heated under nitrogen stream while stirring. When the inner temperature reached 45°C, a solution of 0.2 part of sodium pyrophosphate, 0.01 part of ferrous sulfate 7-hydrate and 0.2 part of glucose in 20 parts of ion-exchanged water was added thereto. Then, 0.07 part of cumene hydroperoxide was added to initiate polymerization, and polymerisation was effected for one hour. Next, 50 parts of ion-exchanged water, 0.7 part of potassium rosinate, 30 parts of styrene, 10 parts of acrylonitrile, 0.05 part of t-dodecyimercaptane and 0.01 part of cumene hydroperoxide were added continuously for 3 hours. After polymerization was effected for one hour, 0.2 part of 2,2'-methylene-bis(4-ethylene-6-t-butylphenol) was added to terminate the polymerization. Magnesium sulfate was added to the latex to coagulate resinous components. Then, the resultant was washed with water and further dried to obtain a polybutadiene graft copolymer (a). The graft ratio was 72%, and the limiting viscosity (n) of the acetone soluble matter was 0.47 dl/g.

2-1-2. Silicone/acrylic composite rubber-reinforced styrene resin

"METABLEN SX-006 (trade name)" manufactured by MITSUBISHI RAYON CO., LTD. (a resin modifier which is an acrylonitrile-styrene copolymer grafted onto a silicone/acrylic composite rubber with a rubber content of 50%, a graft ratio of 80%, a limiting viscosity [n] (at 30°C in methyl ethyl ketone) of 0.38 dl/g and a glass transition temperature (Tg) of 135°C) was used.

2-1-3. Silicone rubber-reinforced styrene resin/acrylic rubber-reinforced styrene resin mixture

(Preparation of silicone rubber-reinforced styrene_resin (b-1))

1.3 parts of p-vinylphenylmethyldimethoxysilane and 98.7 parts of octamethylcyclotetrasiloxane were mixed, and placed in a solution of 2.0 parts of dodecylbenzene sulfonic acid in 300 parts of distilled water, and stirred with a homogenizer for 3 minutes to perform emulsification and dispersion. The mixture was poured into a separable flask equipped with a condenser, nitrogen introducing opening and stirrer, and heated at 90°C for 6 hours and maintained at 5°C for 24 hours under stirring and mixing to complete condensation. The resulting polyorganosiloxane rubber-like polymer had a condensation ratio of 93%. This latex was neutralized to pH 7 with an aqueous sodium carbonate solution. The resulting polyorganosiloxane rubber-like polymer latex had an average particle diameter of 0.3 μm.

In a glass flask having an internal volume of 7 liters and equipped with a stirrer, the ingredients for batch-polymerization comprising 100 parts of ion-exchanged water, 1.5 part of potassium oleate, 0.01 part of potassium hydroxide, 0.1 part of t-dodecylmercaptane, 40 parts (as solid matter) of the above polyorganosiloxane latex, 15 parts of styrene and 5 parts of acrylonitrile were placed, and heated under stirring. When the temperature reached 45°C, an activating solution comprising 0.1 part of sodium ethylenediaminetetraacetate, 0.003 part of ferrous sulfate, 0.2 part of formaldehyde sodium sulfoxylate dihydrate and 15 parts of ion-exchanged water, and 0.1 part of diisopropylbenzene hydroperoxide was added, and reaction was continued for an hour.

Then, a mixture of incremental polymerization ingredients comprising 50 parts of ion-exchanged water, 1 part of potassium oleate, 0.02 part of potassium hydroxide, 0.1 part of t-dodecylmercaptane and 0.2 part of diisopropylbenzene hydroperoxide as well as the monomers of 30 parts of styrene and 10 parts of acrylonitrile was added continuously over 3 hours to continue the reaction. After the completion of addition, reaction was further continued for an hour under stirring, and then 0.2 part of 2,2-methylene-bis-(4-ethylene-6-t-butylphenol) was added thereto to obtain a polymer latex. Further, 1.5 parts of sulfuric acid was added to the above latex and allowed to coagulate at 90°C, and dehydration, washing with water and drying were performed to obtain a silicone rubber-reinforced styrene resin (b-1) In a powder form. The graft ratio thereof was 84% and the limiting viscosity [η] (at 30°C in methyl ethyl ketone) was 0.60 dl/g.

(Preparation of acrylic rubber-reinforced styrene resin (b-2))

In a reaction vessel, 50 parts (as solid matter) of a latex with a solid content of 40% of an acrylic rubber-like polymer (with a volume average particle diameter of 100 nm and a gel content of 90%) obtained by emulsion polymerization of 99 parts of n-butyl acrylate and 1 part of allylmethacrylate was placed, and further 1 part of sodium dodecylbenzene sulfonate and 150 parts of ion-exchanged water were placed for dilution. Then, the inside of the reaction vessel was purged with nitrogen, 0.02 part of ethylenediaminetetraacetic acid disodium salt, 0.005 part of ferrous sulfate and 0.3 part of sodium formaldehyde sulfoxylate were added thereto, and heated to 60°C under stirring.

On the other hand, in a vessel, 1.0 part of terpinolene and 0.2 part of cumene hydroperoxide were dissolved in 50 parts of a mixture of 37.5 parts of styrene and 12.5 parts of acrylonitrile, and then the inside of the vessel was purged with nitrogen to obtain a monomer composition.

Next, the above monomer composition was polymerized at 70°C whilst it was added to the above reaction vessel at a constant flow rate over 5 hours, to obtain latex. Magnesium sulfate was added to the latex to coagulate resinous components. Then, the resultant was washed with water and further dried to obtain an acrylic rubber-reinforced styrene resin (b-2). The graft ratio thereof was 93% and the limiting viscosity [η] (at 30°C in methyl ethyl ketone) was 0.30 dl/g.

2-1-4. Styrene-acrylonitrile copolymer

"SAN-H (trade name)" manufactured by Techno Polymer Co., Ltd. (AS resin).

2-1-5. N-phenylmaleimide-acrylonitrile-styrene copolymer

"POLYIMILEX PAS1460 (trade name)" manufactured by NIPPON SHOKUBAI CO., LTD. (N-phenylmaleimide-acrylonitrile-styrene copolymer with an N-phenylmaleimide unit content of 40%)

2-1-6. Polyethylene terephthalate

"NOVAPEX GM700Z (trade name)" manufactured by Mitsubishi Chemical Corporation was used. It had a glass transition temperature (Tg) of 75°C.

2-1-7. Titanium oxide (white)

"TIPAQUE CR-60-2 (trade name)" manufactured by ISHIHARA SANGYO KAISHA, LTD. (average primary particle diameter: 0.21 μm).

"TIPAQUE CR-50-2 (trade name)" manufactured by ISHIHARA SNAGYO KAISHA, LTD. (average primary particle diameter: 0.25 μm).

"TIPAQUE CR-58-2 (trad name)" manufactured by ISHIHARA SNAGYO KAISHA, LTD. (average primary particle diameter: 0.28 μm).

2-2. Molding materials for resin layers (A), (B) and (C)

The components shown in Table 1 or Table 2 were mixed together in a Henschel mixer in a proportion shown in Table 1 or Table 2, and then melt-kneaded in a double-screw extruder (TEX44 manufactured by The Japan Steel Works, LTD., a barrel temperature of 270˚C) to obtain pellets. The resulting composition was evaluated in accordance with the above evaluation methods. The results are shown in Table 1 and Table 2.
Table 1

| | | Layer A/C | | | | | | | | | |
|---|---|---|---|---|---|---|---|---|---|---|---|
| | | ASA-1 | ASA-2 | ASA-3 | ASA-4 | ASA-5 | ASA-6 | ASA-7 | ABS-1 | ASA-8 | PET-1 |
| Thermoplastic Resin (II) | Silicone/acrylic composite rubber-reinforced styrene resin (part) | 30 | 30 | 30 | 30 | 30 | 30 | ----- | ----- | 30 | ----- |
| | Silicone rubber-reinforced styrene resin (part) | ----- | ----- | ----- | ----- | ----- | ----- | 10 | ----- | | ----- |
| | Acrylic (part) rubber-reinforced styrene resin | ----- | ----- | ----- | ----- | ----- | ----- | 22 | ----- | | ----- |
| | Butadiene rubber-reinforced styrene resin (part) | ----- | ----- | ---- | ----- | ----- | ----- | ----- | 40 | | ----- |
| | Styrene-acrylonitrile copolymer (part) | 30 | 30 | 30 | 30 | 30 | 30 | 28 | 20 | 30 | ----- |
| | N-phenylmaleimide-acrylonitrile-styrene copolymer (part) | 40 | 40 | 40 | 40 | 40 | 40 | 40 | 40 | 40 | ----- |
| | Polyethyleneterephthalate (part) | ----- | ----- | ----- | ----- | ----- | ----- | ----- | ----- | ----- | 100 |
| Pigment (titanium oxide) | TIPAQUE CR-60-2 (average primary particle diameter: 0.21 $\mu$m) | ----- | 20 | ----- | 10 | ----- | ----- | ----- | ----- | ----- | ----- |
| | TIPAQUE CR-50-2 (average primary particle diameter: 0.25 $\mu$m) | 20 | ----- | ----- | ----- | 5 | 25 | 20 | 20 | ----- | 15 |
| | TIPAQUE CR-58-2 (average primary particle diameter: 0.28 $\mu$m) | ----- | ----- | 20 | 10 | ----- | ----- | ----- | ----- | ----- | ----- |
| Evaluation Result | Rubber content (%) | 15 | 15 | 15 | 15 | 15 | 15 | 15 | 16 | 15 | ----- |
| | N-phenylmaleimrde unit content (%) | 16 | 16 | 16 | 16 | 16 | 16 | 16 | 16 | 16 | ----- |
| | Glass transition temperature (Tg)(˚C) | 135 | 135 | 135 | 135 | 135 | 135 | 135 | 135 | 135 | 75 |
| | 100 $\mu$ mono layer L value | 92 | 92 | 92 | 92 | 60 | 92 | 92 | 92 | 56 | 92 |

EP 2 279 863 A1

Table 2

| | | Layer (B) | | | | | |
|---|---|---|---|---|---|---|---|
| | | ASA-9 | ASA-10 | ABS-2 | ASA-11 | ASA-12 | PET-2 |
| Thermoplastic Resin (I) | Silicone/acrylic composite rubber-reinforced styrene resin (part) | 30 | ----- | ----- | 30 | 30 | ----- |
| | Silicone rubber-reinforced styrene resin (part) | ----- | 10 | ----- | ----- | ----- | ----- |
| | Acrylic rubber-reinforced styrene resin (part) | ----- | 22 | ----- | ----- | ----- | ----- |
| | Butadiene rubber-reinforced styrene resin (part) | ----- | ----- | 40 | ----- | ----- | ----- |
| | Styrene-acrylonithle copolymer (part) | 8 | 6 | 8 | 8 | 70 | ----- |
| | N-phenylmaleimide-acrylonitrile-styrene copolymer (part) | 62 | 62 | 62 | 62 | ----- | ----- |
| | Polyethyleneterephthalate (part) | ----- | ----- | ----- | ----- | ----- | 100 |
| Pigment (titanium oxide) | TIPAQUE CR-60-2 (average primary particle diameter: 0.21 μm) | ----- | ----- | ----- | 20 | ----- | ----- |
| Evaluation Result | Rubber content (%) | 15 | 15 | 16 | 15 | 15 | ----- |
| | N-phenylmaleimide unit content (%) | 24.8 | 24.8 | 24.8 | 24.8 | 0 | ----- |
| | Glass transition temperature (Tg)(˚C) | 155 | 155 | 155 | 155 | 108 | 75 |
| | 100μ mono layer L value | 56 | 57 | 56 | 92 | 56 | 53 |

2-3. Material for layer (D) (water vapor barrier layer)

A water vapor barrier layer shown in Table 3 was used. These water vapor barrier films are those comprising a transparent polyethylene terephthalate (PET) film which is formed on one surface thereof with a transparent thin film layer made of a metal and/or metal oxide. Meanwhile, in Table 3, moisture permeability, total light transmittance and haze were respectively measured in accordance with the methods described above.

Table 3

| | Trade name | Thickness (μ) | Moisture permeability (g/m$^2$·d) | Total light transmittance (%) | Haze (%) |
|---|---|---|---|---|---|
| WVB-1 | "TECHBARRIER AX" manufactured by MITSUBISHI PLASTICS, INC. | 12 | 0.15 | 89 | 4.0 |

(continued)

|  | Trade name | Thickness ($\mu$) | Moisture permeability (g/m$^2$·d) | Total light transmittance (%) | Haze (%) |
|---|---|---|---|---|---|
| WVB-2 | "ECOSYAR VE500" manufactured by Toyobo Co., Ltd. | 12 | 0.5 | 90 | 2.6 |

2-4. Layer (E) (protective layer)

The following commercially available PET films were used.

(E-1): PET film "LUMIRROR X10S (trade name)" manufactured by TORAY INDUSTRIES INC. with a thickness of 50 $\mu$m.
(E-2): PET film "Melinex 238 (trade name)" manufactured by Teijin Dupont Film Japan Limited with a thickness of 75 $\mu$m.
(E-3): PEN film "Theonex Q51 (trade name)" manufactured by Teijin Dupont Film Japan Limited with a thickness of 50 $\mu$m.

3-1. Production of layered film (Examples I-1 to I-14, Comparative Examples I-1 to I-9)

Films were produced by the following method.
First, a multi-layer film molding machine provided with T-die (die with; 1400 mm, lip distance; 0.5 mm) and three extruders with a screw diameter of 65 mm was provided, and the above pellets were supplied to the respective extruders as shown in Table 4-1 or 4-2 so that the resins were ejected at a melting temperature of 270°C from the T-die to produce a soft film. Then, the soft film was brought into surface-to-surface contact with a cast roll (roll surface temperature; 95°C) by air knife, and cooled and solidified to obtain a film. In this instance, by adjusting operation conditions of the extruders and cast roll, the thickness of the whole film and the respective thicknesses of resin layer (A)/resin layer (B)/resin layer (C) were controlled to the values shown in Table 4-1 or 4-2. The evaluation results of the resulting films are shown in Table 4-1 or 4-2.
Meanwhile, the thickness of the film was measured by cutting out a film one hour after the initiation of production of the film, and measuring a thickness at the center and each site at an interval of 10 mm from the center to both terminals in the transverse direction of the film using a thickness gage (type "ID-C1112C" manufactured by Mitutoyo Corporation), and was taken as an average value thereof. Values measured at sites within a range of 20 mm from the film terminals were omitted from the calculation of the above average value.
Table 4-1

| | | | Ex. I-1 | Ex. I-2 | Ex. I-3 | Ex. I-4 | Ex. I-5 | Ex. I-6 | Ex. I-7 | Ex. I-8 | Ex. I-9 | Ex. I-10 | Ex. I-11 | Ex. I-12 | Ex. I-13 | Ex. I-14 |
|---|---|---|---|---|---|---|---|---|---|---|---|---|---|---|---|---|
| Layer constitution | Resin layer (A) | Material | ASA-1 | ASA-1 | ASA-1 | ASA-2 | ASA-3 | ASA-4 | ASA-4 | ASA-8 | ASA-4 | ASA-5 | ASA-6 | ASA-7 | ABS-1 | ASA-1 |
| | | $Tg$ (°C) | 135 | 135 | 135 | 135 | 135 | 135 | 135 | 135 | 135 | 135 | 135 | 135 | 135 | 135 |
| | | Pigment color | White | White | White | White | White | White | White | | White | White | White | White | White | White |
| | | Thickness $H_A$ (μ) | 20 | 60 | 90 | 50 | 40 | 120 | 120 | 120 | 120 | 60 | 60 | 60 | 35 | 35 |
| | Resin layer (B) | Material | ASA-9 | ASA-9 | ASA-9 | ASA-10 | ASA-9 | ASA-10 | ASA-11 | ASA-11 | ASA-10 | ASA-10 | ASA-9 | ASA-9 | ABS-2 | ASA-11 |
| | | $Tg$ (°C) | 155 | 155 | 155 | 155 | 155 | 155 | 155 | 155 | 155 | 155 | 155 | 155 | 155 | 155 |
| | | Pigment color | ---- | ---- | ---- | ---- | ---- | ---- | White | White | ---- | ---- | ---- | ---- | ---- | White |
| | | Thickness $H_B$ (μ) | 60 | 120 | 150 | 120 | 150 | 120 | 120 | 120 | 120 | 120 | 120 | 120 | 100 | 100 |
| | Resin layer (C) | Material | ASA-1 | ASA-1 | ASA-1 | ASA-2 | ASA-3 | ASA-4 | ASA-4 | ASA-8 | ASA-8 | ASA-5 | ASA-6 | ASA-7 | ABS-1 | ASA-1 |
| | | $Tg$ (°C) | 135 | 135 | 135 | 135 | 135 | 135 | 135 | 135 | 135 | 135 | 135 | 135 | 135 | 135 |
| | | Pigment color | White | White | White | White | White | White | White | ---- | ---- | White | White | White | White | White |
| | | Thickness $H_C$ (μ) | 20 | 60 | 90 | 60 | 50 | 120 | 120 | 120 | 120 | 60 | 60 | 60 | 35 | 35 |
| | Thickness of the whole layered product (μ) | | 100 | 240 | 330 | 230 | 240 | 360 | 360 | 360 | 360 | 240 | 240 | 240 | 170 | 170 |
| | Difference between Tg of resin layer (B) and Tg of resin layer (A) (°C) | | 20 | 20 | 20 | 20 | 20 | 20 | 20 | 20 | 20 | 20 | 20 | 20 | 20 | 20 |
| | Difference between Tg of resin layer (B) and Tg of resin layer (C) (°C) | | 20 | 20 | 20 | 20 | 20 | 20 | 20 | 20 | 20 | 20 | 20 | 20 | 20 | 20 |
| | $H_A/H_C$ | | 1.0 | 1.0 | 1.0 | 0.8 | 0.8 | 1.0 | 1.0 | 1.0 | 1.0 | 1.0 | 1.0 | 1.0 | 1.0 | 1.0 |
| | $(H_A+H_C)/H_B$ | | 0.7 | 1.0 | 1.2 | 0.9 | 0.6 | 2.0 | 2.0 | 2.0 | 2.0 | 1.0 | 1.0 | 1.0 | 0.7 | 0.7 |
| Evaluation results | Reflectance of a light with a wavelength of 400-1400 nm of layered product (%) | | 75 | 88 | 90 | 86 | 80 | 92 | 94 | 90 | 87 | 75 | 92 | 87 | 78 | 79 |
| | L value of surface on resin layer (A) side of layered product | | 72 | 92 | 93 | 92 | 92 | 93 | 93 | 92 | 92 | 92 | 92 | 92 | 73 | 74 |
| | Dimensional change after 30 min. at 150°C of layered product | | 0.4 | 0.3 | 0.3 | 0.3 | 0.3 | 0.3 | 0.3 | 0.3 | 0.3 | 0.3 | 0.3 | 0.3 | 0.4 | 0.4 |
| | Dimensional change after 30 min. at 150°C of resin layer (B) of layered product | | 0.4 | 0.3 | 0.3 | 0.3 | 0.3 | 0.3 | 0.3 | 0.3 | 0.3 | 0.3 | 0.3 | 0.3 | 0.4 | 0.4 |
| | Flexibility (bending test) | | ◎ | ◎ | ◎ | ◎ | ◎ | ◎ | ◎ | ◎ | ◎ | ◎ | ◎ | ◎ | ◎ | ◎ |
| | Hydrolytic resistance (pressure cooker test) | 100 hours later | Retention of fracture stress | ○ | ○ | ○ | ○ | ○ | ○ | ○ | ○ | ○ | ○ | ○ | ○ | ○ | ○ |
| | | | Retention of elongation | ○ | ○ | ○ | ○ | ○ | ○ | ○ | ○ | ○ | ○ | ○ | ○ | ○ | ○ |
| | | | Deformation condition | ○ | ○ | ○ | ○ | ○ | ○ | ○ | ○ | ○ | ○ | ○ | ○ | ○ | ○ |
| | | 200 hours later | Retention of fracture stress | ○ | ○ | ○ | ○ | ○ | ○ | ○ | ○ | ○ | ○ | ○ | ○ | ○ | ○ |
| | | | Retention of elongation | ○ | ○ | ○ | ○ | ○ | ○ | ○ | ○ | ○ | ○ | ○ | ○ | ○ | ○ |
| | | | Deformation condition | ○ | ○ | ○ | ○ | ○ | ○ | ○ | ○ | ○ | ○ | ○ | ○ | ○ | ○ |
| | Improvement rate of conversion efficiency (%) | | 18 | 25 | 26 | 23 | 19 | 27 | 26 | 25 | 19 | 18 | 26 | 25 | 19 | 19 |
| | Weatherability | | ○ | ○ | ○ | ○ | ○ | ○ | ○ | ○ | ○ | ○ | ○ | ○ | ---- | ○ |

Table 4-2

| Comparative Examples | | | | Comp. Ex. I-1 | Comp. Ex. I-2 | Comp. Ex. I-3 | Comp. Ex. I-4 | Comp. Ex. I-5 | Comp. Ex. I-6 | Comp. Ex. I-7 | Comp. Ex. I-8 | Comp. Ex. I-9 |
|---|---|---|---|---|---|---|---|---|---|---|---|---|
| Layer constitution | Resin layer (A) | | Material | ASA-4 | — | ASA-5 | ASA-8 | ASA-3 | ASA-3 | ASA-1 | ASA-1 | PET-1 |
| | | | Tg (°C) | 135 | — | 135 | 135 | 135 | 135 | 135 | 135 | 75 |
| | | | Pigment color | White | — | White | — | White | White | White | White | White |
| | | | Thickness $H_A$ (μ) | 70 | — | 60 | 60 | 40 | 140 | 30 | 100 | 50 |
| | Resin layer (B) | | Material | — | ASA-11 | ASA-12 | ASA-10 | ASA-10 | ASA-10 | ASA-9 | ASA-9 | PET-2 |
| | | | Tg (°C) | — | 155 | 108 | 155 | 155 | 155 | 155 | 155 | 75 |
| | | | Pigment color | — | White | — | — | — | — | — | — | — |
| | | | Thickness $H_B$ (μ) | — | 150 | 120 | 120 | 120 | 140 | 200 | 80 | 100 |
| | Resin layer (C) | | Material | ASA-4 | — | ASA-5 | ASA-8 | ASA-3 | ASA-3 | ASA-1 | ASA-2 | PET-1 |
| | | | Tg (°C) | 135 | — | 135 | 135 | 135 | 135 | 135 | 135 | 75 |
| | | | Pigment color | White | — | White | — | White | White | White | White | White |
| | | | Thickness $H_C$ (μ) | 80 | — | 60 | 60 | 120 | 100 | 30 | 100 | 50 |
| | Thickness of the whole layered product (μ) | | | 150 | 150 | 240 | 240 | 280 | 380 | 260 | 280 | 200 |
| | Difference between Tg of resin layer (B) and Tg of resin layer (A) (°C) | | | — | — | -27 | 20 | 20 | 20 | 20 | 20 | 0 |
| | Difference between Tg of resin layer (B) and Tg of resin layer (C) (°C) | | | — | — | -27 | 20 | 20 | 20 | 20 | 20 | 0 |
| | $H_A/H_C$ | | | 0.9 | — | 1.0 | 1.0 | 0.3 | 1.4 | 1.0 | 1.0 | 1.0 |
| | $(H_A+H_C)/H_B$ | | | — | — | 1.0 | 1.0 | 1.3 | 1.7 | 0.3 | 2.5 | 1.0 |
| Evaluation results | Reflectance of a light with a wavelength of 400-1400 nm of layered product (%) | | | 90 | 89 | 86 | 23 | 89 | 92 | 78 | 91 | 91 |
| | L value of surface on resin layer (A) side of layered product | | | 92 | 92 | 92 | 56 | 92 | 92 | 92 | 90 | 90 |
| | Dimensional change after 30 min. at 150°C of layered product | | | 1.8 | 0.2 | 1.4 | 0.3 | 0.3 | 0.3 | 0.2 | 1.2 | 1.2 |
| | Dimensional change after 30 min. at 150°C of resin layer (B) of layered product | | | — | 0.2 | 1.4 | 0.3 | 0.3 | 0.3 | 0.2 | 0.3 | 1.2 |
| | Flexibility (bending test) | | | ◎ | × | ◎ | ◎ | ◎ | ◎ | × | ◎ | ◎ |
| | Hydrolytic resistance (pressure cooker test) | 100 hours later | Retention of fracture stress | ○ | ○ | ○ | ○ | ○ | ○ | ○ | ○ | × |
| | | | Retention of elongation | ○ | ○ | ○ | ○ | ○ | ○ | ○ | ○ | × |
| | | | Deformation condition | ○ | ○ | ○ | ○ | × | × | ○ | ○ | ○ |
| | | 200 hours later | Retention of fracture stress | ○ | ○ | ○ | ○ | ○ | ○ | ○ | ○ | × |
| | | | Retention of elongation | ○ | ○ | ○ | ○ | ○ | ○ | ○ | ○ | × |
| | | | Deformation condition | ○ | ○ | ○ | ○ | × | × | ○ | ○ | ○ |
| | Improvement rate of conversion efficiency (%) | | | 13 | 18 | 24 | 0.2 | 25 | 27 | 18 | 14 | 24 |
| | Weatherability | | | ○ | ○ | ○ | ○ | ○ | ○ | ○ | ○ | × |

From the results of Table 4-1, it was found that the layered products of Example I-1 to I-14 were high in light reflectance, excellent in conversion efficiency of solar cells and excellent in heat resistance, and further excellent in weatherability, hydrolytic resistance and flexibility.

From the results of Table 4-2, the followings were found.

Comparative Example I-1 involving a two-layered product without the resin layer (B) high in heat resistance was inferior in heat resistance.

Comparative Example I-2 involving a mono-layered product of the resin layer (B) high in heat resistance was inferior in flexibility.

Comparative Example I-3 involving a three-layered product with the resin layer (B) inferior in heat resistance was inferior in flexibility.

Comparative Example I-4 involving a three-layered product, in which none of the layers comprised a white pigment and a reflectance of a light with wavelength of 400-1400 nm was less than 50%, was inferior in conversion efficiency of solar cells.

Comparative Example I-5 involving a three-layered product with $H_A/H_C$ of less than 0.5 caused a curl in pressure cooker test, and was inferior in thermal deformation.

Comparative Example I-6 involving a three-layered product with $H_A/H_C$ exceeding 1.3 caused a curl in pressure cooker test, and was inferior in thermal deformation.

Comparative Example I-7 involving a three-layered product with $(H_A/H_C)/H_B$ of less than 0.4 was inferior in flexibility.

Comparative Example I-8 involving a three-layered product with $(H_A/H_C)/H_B$ exceeding 2.4 was inferior in heat resistance.

Comparative Example I-9 involving a three-layered product, in which all the layers were constituted by polyethylene terephthalate low in a glass transition temperature, was inferior in heat resistance, and also inferior in hydrolytic resistance and weatherability.

3-2. Example I-15 to I-24

A PET film or a PEN film of Table 5 was stuck on the outer surface of the layer (C) of the film described in Table 5 using a polyurethane adhesive agent (coating thickness 8 μm). Using the resulting film as a test piece, evaluation was conducted in accordance with the above evaluation methods. The results are shown in Table 5.

From Table 5, it was found that scratch resistance and flame resistance were provided by layering a protective layer on the layered product of the present invention.

Table 5

| | | | Ex. I-15 | Ex. I-16 | Ex. I-17 | Ex. I-18 | Ex. I-19 | Ex. I-20 | Ex. I-21 | Ex. I-22 | Ex. I-23 | Ex. I-24 |
|---|---|---|---|---|---|---|---|---|---|---|---|---|
| Layer constitution | Resin layer (A) | Material | ASA-1 | ASA-1 | ASA-1 | ASA-4 | ASA-4 | ASA-4 | ASA-1 | ASA-1 | ASA-1 | ASA-1 |
| | | Tg (°C) | 135 | 135 | 135 | 135 | 135 | 135 | 135 | 135 | 135 | 135 |
| | | Pigment color | White | White | White | White | White | White | White | White | White | White |
| | | Thickness $H_A$ (μ) | 60 | 60 | 60 | 120 | 120 | 120 | 35 | 35 | 35 | 30 |
| | Resin layer (B) | Material | ASA-9 | ASA-9 | ASA-9 | ASA-11 | ASA-11 | ASA-11 | ASA-11 | ASA-11 | ASA-11 | ASA-11 |
| | | Tg (°C) | 155 | 155 | 155 | 155 | 155 | 155 | 155 | 155 | 155 | 155 |
| | | Pigment color | — | — | — | White | White | White | White | White | White | White |
| | | Thickness $H_B$ (μ) | 120 | 120 | 120 | 120 | 120 | 120 | 100 | 100 | 100 | 90 |
| | Resin layer (C) | Material | ASA-1 | ASA-1 | ASA-1 | ASA-4 | ASA-4 | ASA-4 | ASA-1 | ASA-1 | ASA-1 | ASA-1 |
| | | Tg (°C) | 135 | 135 | 135 | 135 | 135 | 135 | 135 | 135 | 135 | 135 |
| | | Pigment color | White | White | White | White | White | White | White | White | White | White |
| | | Thickness $H_C$ (μ) | 60 | 60 | 60 | 120 | 120 | 120 | 35 | 35 | 35 | 30 |
| | Protective layer (E) | | D-1 | D-2 | D-3 | D-1 | D-2 | D-3 | D-1 | D-2 | D-3 | D-1 |
| | Thickness of resin layers (A), (B) and (C) (μ) | | 240 | 240 | 240 | 360 | 360 | 360 | 170 | 170 | 170 | 150 |
| | Thickness of the whole layered product (μ) | | 298 | 323 | 298 | 418 | 443 | 418 | 228 | 253 | 228 | 208 |
| | Difference between Tg of resin layer (B) and Tg of resin layer (A) (°C) | | 20 | 20 | 20 | 20 | 20 | 20 | 20 | 20 | 20 | 20 |
| | Difference between Tg of resin layer (B) and Tg of resin layer (C) (°C) | | 20 | 20 | 20 | 20 | 20 | 20 | 20 | 20 | 20 | 20 |
| | $H_A/H_C$ | | 1.0 | 1.0 | 1.0 | 1.0 | 1.0 | 1.0 | 1.0 | 1.0 | 1.0 | 1.0 |
| | $(H_A+H_C)/H_B$ | | 1.0 | 1.0 | 1.0 | 2.0 | 2.0 | 2.0 | 0.7 | 0.7 | 0.7 | 0.7 |
| Evaluation results | Reflectance of a light with a wavelength of 400-1400 nm of layered product (%) | | 89 | 88 | 88 | 94 | 94 | 94 | 78 | 79 | 79 | 76 |
| | L value of surface on resin layer (A) side of layered product | | 92 | 92 | 93 | 93 | 93 | 92 | 74 | 73 | 73 | 73 |
| | Dimensional change after 30 min. at 150°C of layered product | | 0.3 | 0.3 | 0.3 | 0.3 | 0.3 | 0.3 | 0.3 | 0.3 | 0.3 | 0.3 |
| | Dimensional change after 30 min. at 150°C of resin layer (B) of layered product | | 0.3 | 0.2 | 0.3 | 0.2 | 0.3 | 0.3 | 0.4 | 0.3 | 0.3 | 0.3 |
| | Flexibility (bending test) | | ◎ | ◎ | ◎ | ◎ | ◎ | ◎ | ◎ | ◎ | ◎ | ◎ |
| | Hydrolytic resistance (pressure cooker test) | 100 hours later — Retention of fracture stress | ○ | ○ | ○ | ○ | ○ | ○ | ○ | ○ | ○ | ○ |
| | | 100 hours later — Retention of elongation | ○ | ○ | ○ | ○ | ○ | ○ | ○ | ○ | ○ | ○ |
| | | 100 hours later — Deformation condition | ○ | ○ | ○ | ○ | ○ | ○ | ○ | ○ | ○ | ○ |
| | | 200 hours later — Retention of fracture stress | ○ | ○ | ○ | ○ | ○ | ○ | ○ | ○ | ○ | ○ |
| | | 200 hours later — Retention of elongation | ○ | ○ | ○ | ○ | ○ | ○ | ○ | ○ | ○ | ○ |
| | | 200 hours later — Deformation condition | ○ | ○ | ○ | ○ | ○ | ○ | ○ | ○ | ○ | ○ |
| | Improvement rate of conversion efficiency (%) | | 24 | 23 | 24 | 26 | 25 | 25 | 19 | 18 | 19 | 18 |
| | Weatherability | | ○ | ○ | ○ | ○ | ○ | ○ | ○ | ○ | ○ | ○ |
| | Scratch resistance | | ○ | ○ | ○ | ○ | ○ | ○ | ○ | ○ | ○ | ○ |
| | Flame resistance | | ○ | ○ | ○ | ○ | ○ | ○ | ○ | ○ | ○ | ○ |

3-3. Example II-1 to II-14 and Comparative Example II-1 to II-10

A layer (D) comprising a film shown in Table 6-1 or 6-2 was stuck on the surface of the layer (A) of each film obtained in 3-1 using an adhesive agent shown in Table 6-1 or 6-2. In this instance, the thin film layer (water vapor barrier layer) of the water vapor barrier film constituting the layer (D) was layered on a layer (A). That is, the layered product with a constitution shown, in Figure 1 was obtained. The evaluation results of the resulting film are shown in Table 6-1 or 6-2.

Meanwhile, measurement of the thickness of the film was conducted in the same manner as above.

Table 6-1

| | | | Ex. II-1 | Ex. II-2 | Ex. II-3 | Ex. II-4 | Ex. II-5 | Ex. II-6 | Ex. II-7 | Ex. II-8 | Ex. II-9 | Ex. II-10 | Ex. II-11 | Ex. II-12 | Ex. II-13 | Ex. II-14 |
|---|---|---|---|---|---|---|---|---|---|---|---|---|---|---|---|---|
| Layer constitution | Resin layer (A) | Material | ASA-1 | ASA-1 | ASA-1 | ASA-2 | ASA-3 | ASA-4 | ASA-4 | ASA-8 | ASA-4 | ASA-5 | ASA-6 | ASA-7 | ABS-1 | ASA-1 |
| | | Tg (°C) | 135 | 135 | 135 | 135 | 135 | 135 | 135 | 135 | 135 | 135 | 135 | 135 | 135 | 135 |
| | | Pigment color | White | White | White | White | White | White | White | ---- | White | White | White | White | White | White |
| | | Thickness $H_A$ (μ) | 20 | 60 | 90 | 50 | 40 | 120 | 120 | 120 | 120 | 60 | 60 | 60 | 35 | 35 |
| | Resin layer (B) | Material | ASA-9 | ASA-9 | ASA-9 | ASA-10 | ASA-9 | ASA-10 | ASA-11 | ASA-11 | ASA-10 | ASA-10 | ASA-9 | ASA-9 | ABS-2 | ASA-11 |
| | | Tg (°C) | 155 | 155 | 155 | 155 | 155 | 155 | 155 | 155 | 155 | 155 | 155 | 155 | 155 | 155 |
| | | Pigment color | ---- | ---- | ---- | ---- | ---- | ---- | White | White | ---- | ---- | ---- | ---- | ---- | White |
| | | Thickness $H_B$ (μ) | 60 | 120 | 150 | 120 | 150 | 120 | 120 | 120 | 120 | 120 | 120 | 120 | 100 | 100 |
| | Resin layer (C) | Material | ASA-1 | ASA-1 | ASA-1 | ASA-2 | ASA-3 | ASA-4 | ASA-4 | ASA-8 | ASA-8 | ASA-5 | ASA-6 | ASA-7 | ABS-1 | ASA-1 |
| | | Tg (°C) | 135 | 135 | 135 | 135 | 135 | 135 | 135 | 135 | 135 | 135 | 135 | 135 | 135 | 135 |
| | | Pigment color | White | White | White | White | White | White | White | ---- | ---- | White | White | White | White | White |
| | | Thickness $H_C$ (μ) | 20 | 60 | 90 | 60 | 50 | 120 | 120 | 120 | 120 | 60 | 60 | 60 | 35 | 35 |
| | Layer (D) — Film | Material | WVB-1 | WVB-1 | WVB-2 | WVB-2 | WVB-2 | WVB-2 | WVB-2 | WVB-2 | WVB-2 | WVB-2 | WVB-2 | WVB-2 | WVB-1 | WVB-1 |
| | | Thickness (μ) | 12 | 12 | 12 | 12 | 12 | 12 | 12 | 12 | 12 | 12 | 12 | 12 | 12 | 12 |
| | Layer (D) — Adhesive layer | Material | Poly urethane | Poly urethane | Poly urethane | Poly urethane | Poly urethane | Poly urethane | Poly urethane | Poly urethane | Poly urethane | Poly urethane | Poly urethane | Poly urethane | Poly urethane | Poly urethane |
| | | Thickness (μ) | 5 | 3 | 5 | 5 | 3 | 5 | 5 | 5 | 5 | 5 | 5 | 3 | 8 | 8 |
| | Thickness of resin layers (A), (B) and (C) (μ) | | 100 | 240 | 330 | 230 | 240 | 360 | 360 | 360 | 360 | 240 | 240 | 240 | 170 | 170 |
| | Thickness of the whole back sheet (μ) | | 117 | 255 | 347 | 247 | 255 | 377 | 377 | 377 | 377 | 257 | 257 | 255 | 190 | 190 |
| | Difference between Tg of resin layer (B) and Tg of resin layer (A) (°C) | | 20 | 20 | 20 | 20 | 20 | 20 | 20 | 20 | 20 | 20 | 20 | 20 | 20 | 20 |
| | Difference between Tg of resin layer (B) and Tg of resin layer (C) (°C) | | 20 | 20 | 20 | 20 | 20 | 20 | 20 | 20 | 20 | 20 | 20 | 20 | 20 | 20 |
| | $H_A/H_C$ | | 1.0 | 1.0 | 1.0 | 0.8 | 0.8 | 1.0 | 1.0 | 1.0 | 1.0 | 1.0 | 1.0 | 1.0 | 1.0 | 1.0 |
| | $(H_A+H_C)/H_B$ | | 0.7 | 1.0 | 1.2 | 0.9 | 0.6 | 2.0 | 2.0 | 2.0 | 2.0 | 1.0 | 1.0 | 1.0 | 0.7 | 0.7 |
| Evaluation results | Reflectance of a light with a wavelength of 400-1400 nm of layered product (%) | | 75 | 88 | 90 | 86 | 80 | 92 | 94 | 90 | 87 | 75 | 92 | 92 | 78 | 78 |
| | L value of surface on resin layer (A) side of layered product | | 72 | 92 | 93 | 92 | 92 | 93 | 93 | 92 | 92 | 92 | 92 | 92 | 73 | 73 |
| | Dimensional change after 30 min. at 150°C of layered product | | 0.4 | 0.3 | 0.3 | 0.3 | 0.3 | 0.3 | 0.3 | 0.3 | 0.3 | 0.3 | 0.3 | 0.3 | 0.3 | 0.3 |
| | Dimensional change after 30 min. at 150°C of resin layer (B) of layered product | | 0.4 | 0.3 | 0.3 | 0.3 | 0.3 | 0.3 | 0.3 | 0.3 | 0.3 | 0.3 | 0.3 | 0.3 | 0.3 | 0.3 |
| | Flexibility (bending test) | | ◎ | ◎ | ◎ | ◎ | ◎ | ◎ | ◎ | ◎ | ◎ | ◎ | ◎ | ◎ | ◎ | ◎ |
| | Hydrolytic resistance (pressure cooker test) — 100 hours later | Retention of fracture stress | ○ | ○ | ○ | ○ | ○ | ○ | ○ | ○ | ○ | ○ | ○ | ○ | ○ | ○ |
| | | Retention of elongation | ○ | ○ | ○ | ○ | ○ | ○ | ○ | ○ | ○ | ○ | ○ | ○ | ○ | ○ |
| | | Deformation condition | ○ | ○ | ○ | ○ | ○ | ○ | ○ | ○ | ○ | ○ | ○ | ○ | ○ | ○ |
| | Hydrolytic resistance (pressure cooker test) — 200 hours later | Retention of fracture stress | ○ | ○ | ○ | ○ | ○ | ○ | ○ | ○ | ○ | ○ | ○ | ○ | ○ | ○ |
| | | Retention of elongation | ○ | ○ | ○ | ○ | ○ | ○ | ○ | ○ | ○ | ○ | ○ | ○ | ○ | ○ |
| | | Deformation condition | ○ | ○ | ○ | ○ | ○ | ○ | ○ | ○ | ○ | ○ | ○ | ○ | ○ | ○ |
| | Improvement rate of conversion efficiency (%) | | 18 | 25 | 26 | 23 | 19 | 27 | 26 | 25 | 19 | 18 | 26 | 25 | 19 | 19 |
| | Weatherability | | ○ | ○ | ○ | ○ | ○ | ○ | ○ | ○ | ○ | ○ | ○ | ○ | ---- | ○ |
| | Water vapor barrier property (permeability test: g/m²·d) | | 0.5 | 0.3 | 0.3 | 0.4 | 0.4 | 0.4 | 0.4 | 0.4 | 0.4 | 0.4 | 0.4 | 0.4 | 0.4 | 0.4 |

Table 6-2

| | | | | Comp. Ex. II-1 | Comp. Ex. II-2 | Comp. Ex. II-3 | Comp. Ex. II-4 | Comp. Ex. II-5 | Comp. Ex. II-6 | Comp. Ex. II-7 | Comp. Ex. II-8 | Comp. Ex. II-9 | Comp. Ex. II-10 |
|---|---|---|---|---|---|---|---|---|---|---|---|---|---|
| Layer constitution | Resin layer (A) | | Material | ASA-1 | ASA-4 | — | ASA-5 | ASA-8 | ASA-3 | ASA-3 | ASA-1 | ASA-1 | PET-1 |
| | | | Tg (°C) | 135 | 135 | — | 135 | 135 | 135 | 135 | 135 | 135 | 75 |
| | | | Pigment color | White | White | — | White | — | White | White | White | White | White |
| | | | Thickness $H_A$ (μ) | 20 | 70 | — | 60 | 60 | 40 | 140 | 30 | 100 | 50 |
| | Resin layer (B) | | Material | ASA-10 | — | ASA-11 | ASA-12 | ASA-10 | ASA-10 | ASA-10 | ASA-9 | ASA-9 | PET-2 |
| | | | Tg (°C) | 155 | — | 155 | 108 | 155 | 155 | 155 | 155 | 155 | 75 |
| | | | Pigment color | — | — | White | — | — | — | — | — | — | — |
| | | | Thickness $H_B$ (μ) | 60 | — | 150 | 120 | 120 | 120 | 140 | 200 | 80 | 100 |
| | Resin layer (C) | | Material | ASA-1 | ASA-4 | — | ASA-5 | ASA-8 | ASA-3 | ASA-3 | ASA-1 | ASA-2 | PET-1 |
| | | | Tg (°C) | 135 | 135 | — | 135 | 135 | 135 | 135 | 135 | 135 | 75 |
| | | | Pigment color | White | White | — | White | — | White | White | White | White | White |
| | | | Thickness $H_C$ (μ) | 20 | 80 | — | 60 | 60 | 120 | 100 | 30 | 100 | 50 |
| | Layer (D) | Film | Material | — | WVB-1 | WVB-2 | WVB-1 | WVB-1 | WVB-1 | WVB-1 | WVB-2 | WVB-1 | WVB-1 |
| | | | Thickness (μ) | — | 12 | 12 | 12 | 12 | 12 | 12 | 12 | 12 | 12 |
| | | Adhesive layer | Material | — | Poly urethane | Poly urethane | Poly urethane | Poly urethane | Poly urethane | Poly urethane | Poly urethane | Poly urethane | Poly urethane |
| | | | Thickness (μ) | — | 3 | 3 | 5 | 5 | 5 | 3 | 3 | 5 | 5 |
| | Thickness of the whole back sheet (μ) | | | 100 | 165 | 150 | 257 | 257 | 297 | 395 | 275 | 297 | 217 |
| | Difference between Tg of resin layer (B) and Tg of resin layer (A) (°C) | | | 20 | — | — | -27 | 20 | 20 | 20 | 20 | 20 | 0 |
| | Difference between Tg of resin layer (B) and Tg of resin layer (C) (°C) | | | 20 | — | — | -27 | 20 | 20 | 20 | 20 | 20 | 0 |
| | $H_A/H_C$ | | | 1.0 | 0.9 | — | 1.0 | 1.0 | 0.3 | 1.4 | 1.0 | 1.0 | 1.0 |
| | $(H_A+H_C)/H_B$ | | | 0.7 | — | — | 1.0 | 1.0 | 1.3 | 1.7 | 0.3 | 2.5 | 1.0 |
| Evaluation results | Reflectance of a light with a wavelength of 400-1400 nm of layered product (%) | | | 86 | 90 | 89 | 86 | 23 | 89 | 92 | 78 | 91 | 91 |
| | L value of surface on resin layer (A) side of layered product | | | 87 | 92 | 92 | 92 | 56 | 92 | 92 | 92 | 90 | 90 |
| | Dimensional change after 30 min. at 150°C of layered product | | | 0.3 | 1.8 | 0.2 | 1.4 | 0.3 | 0.3 | 0.3 | 0.2 | 1.2 | 1.2 |
| | Dimensional change after 30 min. at 150°C of resin layer (B) of layered product | | | 0.3 | — | 0.2 | 1.4 | 0.3 | 0.3 | 0.3 | 0.2 | 0.3 | 1.2 |
| | Flexibility (bending test) | | | ◎ | ◎ | × | ◎ | ◎ | ◎ | ◎ | × | ◎ | ◎ |
| | Hydrolytic resistance (pressure cooker test) | 100 hours later | Retention of fracture stress | ○ | ○ | ○ | ○ | ○ | ○ | ○ | ○ | ○ | × |
| | | | Retention of elongation | ○ | ○ | ○ | ○ | ○ | ○ | ○ | ○ | ○ | × |
| | | | Deformation condition | ○ | ○ | ○ | ○ | ○ | × | × | ○ | ○ | ○ |
| | | 200 hours later | Retention of fracture stress | ○ | ○ | ○ | ○ | ○ | ○ | ○ | ○ | ○ | × |
| | | | Retention of elongation | ○ | ○ | ○ | ○ | ○ | ○ | ○ | ○ | ○ | × |
| | | | Deformation condition | ○ | ○ | ○ | ○ | ○ | × | × | ○ | ○ | ○ |
| | Improvement rate of conversion efficiency (%) | | | 18 | 13 | 18 | 24 | 0.2 | 25 | 27 | 18 | 14 | 24 |
| | Weatherability | | | ○ | ○ | ○ | ○ | ○ | ○ | ○ | ○ | ○ | × |
| | Water vapor barrier property (permeability test: $g/m^2 \cdot d$) | | | 41 | 0.3 | 0.3 | 0.4 | 0.3 | 0.3 | 0.3 | 0.3 | 0.4 | 0.4 |

In addition, from the results on Table 6-1, the layered products of Example II-1 to II-14 were high in light reflectance, excellent in conversion efficiency of solar cells and excellent in heat resistance and water vapor barrier property, and further excellent in weatherability, hydrolytic resistance and flexibility.

For the respective layered products of Comparative Examples, the followings were found from the results of Table 6-2.

Comparative Example II-1 which was an example lacking a resin layer (D) was inferior in water vapor barrier property.

Comparative Example II-2 involving a two-layered product without a resin layer (B) high in heat resistance was inferior in heat resistance.

Comparative Example II-3 involving a mono-layered product of a resin layer (B) high in heat resistance was inferior in flexibility.

Comparative Example II-4 involving a three-layered product with a resin layer (B) inferior in heat resistance was inferior in heat resistance.

Comparative Example II-5 involving a, three-layered product, in which none of the layers comprised a white pigment and a reflectance of a light with wavelength of 400-1400 nm was less than 50%, was inferior in conversion efficiency of solar cells.

Comparative Example II-6 involving a three-layered product with $H_A/H_C$ of less than 0.5 caused a curl in pressure cooker test, and was inferior in thermal deformation.

Comparative Example II-7 involving a three-layered product with $H_A/H_C$ exceeding 1.3 caused a curl in pressure cooker test, and was inferior in thermal deformation.

Comparative Example II-8 involving a three-layered product with $(H_A/H_C)/H_B$ of less than 0.4 was inferior in flexibility.

Comparative Example II-9 involving a three-layered product with $(H_A/H_C)/H_B$ exceeding 2.4 was inferior in heat resistance.

Comparative Example II-10 involving a three-layered product, in which all the layers were constituted by polyethylene terephtalate low in glass transition temperature., was inferior in heat resistance, and also inferior in hydrolytic resistance and weatherability.

3-4. Example II-15 to II-17

A film was produced in the same manner as in Example II-2, Example II-7 or Example II-14 except that the water vapor barrier layer (D) was layered on the outer surface of the layer (C). In this instance, the layer (D) was layered such that the thin film layer (water vapor barrier layer) of the water vapor barrier film constituting the layer (D) was positioned to be the outer surface. That is, the layered product with a shows in Figure 2 was obtained.

The resulting film was used as a test piece, and evaluation was conducted in accordance with the above evaluation method. The results are shown in Table 7.

Table 7

| | | | | Ex. II-15 | Ex. II-16 | Ex. II-17 |
|---|---|---|---|---|---|---|
| Layer constitution | Resin layer (A) | | Material | ASA-1 | ASA-4 | ASA-1 |
| | | | Tg (°C) | 135 | 135 | 135 |
| | | | Pigment color | White | White | White |
| | | | Thickness $H_A$ (μ) | 60 | 120 | 35 |
| | Resin layer (B) | | Material | ASA-9 | ASA-11 | ASA-11 |
| | | | Tg (°C) | 155 | 155 | 155 |
| | | | Pigment color | --- | White | White |
| | | | Thickness $H_B$ (μ) | 120 | 120 | 100 |
| | Resin layer (C) | | Material | ASA-1 | ASA-4 | ASA-1 |
| | | | Tg (°C) | 135 | 135 | 135 |
| | | | Pigment color | White | White | White |
| | | | Thickness $H_C$ (μ) | 60 | 120 | 35 |
| | Layer (D) | Film | Material | WVB-1 | WVB-2 | WVB-1 |
| | | | Thickness (μ) | 12 | 12 | 12 |
| | | Adhesive layer | Material | Poly urethane | Poly urethane | Poly urethane |
| | | | Thickness (μ) | 3 | 5 | 8 |
| | Thickness of resin layers (A), (B) and (C) (μ) | | | 240 | 360 | 170 |
| | Thickness of the whole back sheet (μ) | | | 255 | 377 | 190 |
| | Difference between Tg of resin layer (B) and Tg of resin layer (A) (°C) | | | 20 | 20 | 20 |
| | Difference between Tg of resin layer (B) and Tg of resin layer (C) (°C) | | | 20 | 20 | 20 |
| | $H_A/H_C$ | | | 1.0 | 1.0 | 1.0 |
| | $(H_A+H_C)/H_B$ | | | 1.0 | 2.0 | 0.7 |
| Evaluation results | Reflectance of a light with a wavelength of 400-1400 nm of layered product (%) | | | 87 | 94 | 79 |
| | L value of surface on resin layer (A) side of layered product | | | 87 | 93 | 72 |
| | Dimensional change after 30 min. at 150°C of layered product | | | 0.3 | 0.3 | 0.3 |
| | Dimensional change after 30 min. at 150°C of resin layer (B) of layered product | | | 0.3 | 0.2 | 0.2 |
| | Flexibility (bending test) | | | ◎ | ◎ | ◎ |
| | Hydrolytic resistance (pressure cooker test) | 100 hours later | Retention of fracture stress | ○ | ○ | ○ |
| | | | Retention of elongation | ○ | ○ | ○ |
| | | | Deformation condition | ○ | ○ | ○ |
| | | 200 hours later | Retention of fracture stress | ○ | ○ | ○ |
| | | | Retention of elongation | ○ | ○ | ○ |
| | | | Deformation condition | ○ | ○ | ○ |
| | Improvement rate of conversion efficiency (%) | | | 24 | 26 | 20 |
| | Weatherability | | | ○ | ○ | ○ |
| | Water vapor barrier property (permeability test: g/m²·d) | | | 0.5 | 0.4 | 0.4 |

3-5. Example II-18

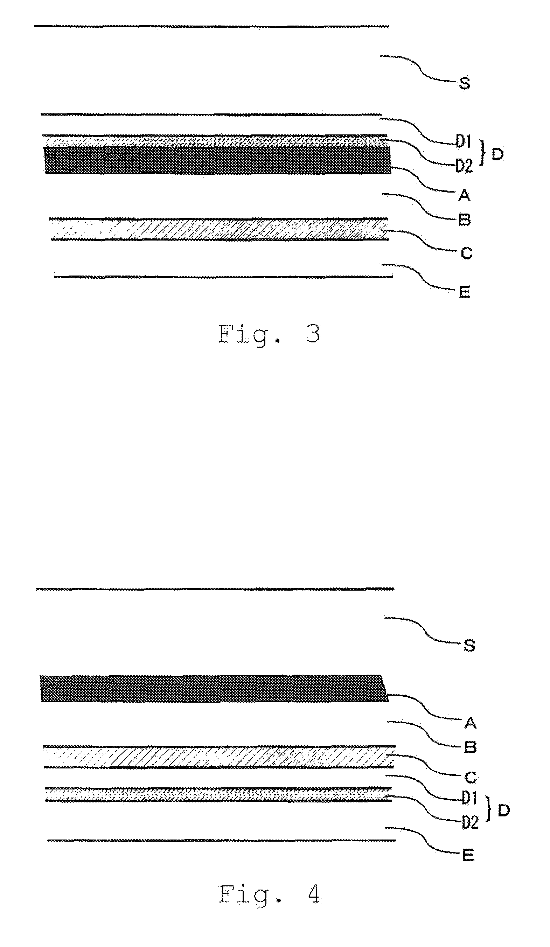

A PET film of Table 8 was stuck as a protective layer (E) on the outer surface of the layer (C) of the film obtained in Example II-2 using a polyurethane adhesive agent (coating thickness: 8 μm). That is, a layered product with a construction shown in Figure 3 was obtained.
Using the resulting film as a test piece, evaluation was conducted in accordance with the above evaluation methods. The results are shown in Table 8.

3-6. Example II-19 to II-27

A PET film or PEN film of Table 8 was stuck as a protective layer (E) on the outer surface of the layer (D) of the film obtained in Example II-15, II-16 or II-17 using a polyurethane adhesive agent (coating thickness: 8 μm). That is, a layered product with a construction shown in Figure 4 was obtained.
Using the resulting film as a test piece, evaluation was conducted in accordance with the above evaluation methods. The results are shown in Table 8.
From Table 8, it is found that scratch resistance and flame resistance are improved by layering a protective layer (E) of the present invention on the outer surface of the resin layer (C) or water vapor barrier layer (D), and this is preferable.

Table 8

| | | | Ex. II-18 | Ex. II-19 | Ex. II-20 | Ex. II-21 | Ex. II-22 | Ex. II-23 | Ex. II-24 | Ex. II-25 | Ex. II-26 | Ex. II-27 |
|---|---|---|---|---|---|---|---|---|---|---|---|---|
| Layer constitution | Resin layer (A) | Material | ASA-1 | ASA-1 | ASA-4 | ASA-1 | ASA-1 | ASA-4 | ASA-1 | ASA-1 | ASA-4 | ASA-1 |
| | | Tg (°C) | 135 | 135 | 135 | 135 | 135 | 135 | 135 | 135 | 135 | 135 |
| | | Pigment color | White | White | White | White | White | White | White | White | White | White |
| | | Thickness $H_A$ (μ) | 60 | 60 | 120 | 35 | 60 | 120 | 35 | 60 | 120 | 35 |
| | Resin layer (B) | Material | ASA-9 | ASA-9 | ASA-11 | ASA-11 | ASA-9 | ASA-11 | ASA-11 | ASA-9 | ASA-11 | ASA-11 |
| | | Tg (°C) | 155 | 155 | 155 | 155 | 155 | 155 | 155 | 155 | 155 | 155 |
| | | Pigment color | — | — | White | White | — | White | White | — | White | White |
| | | Thickness $H_B$ (μ) | 120 | 120 | 120 | 100 | 120 | 120 | 100 | 120 | 120 | 100 |
| | Resin layer (C) | Material | ASA-1 | ASA-1 | ASA-4 | ASA-1 | ASA-1 | ASA-4 | ASA-1 | ASA-1 | ASA-4 | ASA-1 |
| | | Tg (°C) | 135 | 135 | 135 | 135 | 135 | 135 | 135 | 135 | 135 | 135 |
| | | Pigment color | White | White | White | White | White | White | White | White | White | White |
| | | Thickness $H_C$ (μ) | 60 | 60 | 120 | 35 | 60 | 120 | 35 | 60 | 120 | 35 |
| | Layer (D) — Film | Material | WVB-1 | WVB-1 | WVB-2 | WVB-1 | WVB-1 | WVB-2 | WVB-1 | WVB-1 | WVB-2 | WVB-1 |
| | | Thickness (μ) | 12 | 12 | 12 | 12 | 12 | 12 | 12 | 12 | 12 | 12 |
| | Layer (D) — Adhesive layer | Material | Poly urethane | Poly urethane | Poly urethane | Poly urethane | Poly urethane | Poly urethane | Poly urethane | Poly urethane | Poly urethane | Poly urethane |
| | | Thickness (μ) | 3 | 3 | 5 | 8 | 3 | 5 | 8 | 3 | 5 | 8 |
| | Protective layer (E) | | E-1 | E-1 | E-1 | E-1 | E-2 | E-2 | E-2 | E-3 | E-3 | E-3 |
| | Thickness of resin layers (A), (B) and (C) (μ) | | 240 | 240 | 360 | 170 | 240 | 360 | 170 | 240 | 360 | 170 |
| | Thickness of the whole back sheet (μ) | | 313 | 313 | 435 | 248 | 338 | 460 | 273 | 313 | 435 | 248 |
| | Difference between Tg of resin layer (B) and Tg of resin layer (A) (°C) | | 20 | 20 | 20 | 20 | 20 | 20 | 20 | 20 | 20 | 20 |
| | Difference between Tg of resin layer (B) and Tg of resin layer (C) (°C) | | 20 | 20 | 20 | 20 | 20 | 20 | 20 | 20 | 20 | 20 |
| | $H_A/H_C$ | | 1.0 | 1.0 | 1.0 | 1.0 | 1.0 | 1.0 | 1.0 | 1.0 | 1.0 | 1.0 |
| | $(H_A+H_C)/H_B$ | | 1.0 | 1.0 | 2.0 | 0.7 | 1.0 | 2.0 | 0.7 | 1.0 | 2.0 | 0.7 |
| Evaluation results | Reflectance of a light with a wavelength of 400-1400 nm of layered product (%) | | 89 | 93 | 94 | 79 | 94 | 94 | 78 | 93 | 94 | 77 |
| | L value of surface on resin layer (A) side of layered product | | 92 | 94 | 93 | 74 | 92 | 93 | 74 | 93 | 93 | 73 |
| | Dimensional change after 30 min. at 150°C of layered product | | 0.3 | 0.3 | 0.3 | 0.3 | 0.3 | 0.3 | 0.3 | 0.3 | 0.3 | 0.3 |
| | Dimensional change after 30 min. at 150°C of resin layer (B) of layered product | | 0.3 | 0.2 | 0.2 | 0.3 | 0.3 | 0.3 | 0.3 | 0.3 | 0.3 | 0.3 |
| | Flexibility (bending test) | | ◎ | ◎ | ◎ | ◎ | ◎ | ◎ | ◎ | ◎ | ◎ | ◎ |
| | Hydrolytic resistance (pressure cooker test) — 100 hours later | Retention of fracture stress | ○ | ○ | ○ | ○ | ○ | ○ | ○ | ○ | ○ | ○ |
| | | Retention of elongation | ○ | ○ | ○ | ○ | ○ | ○ | ○ | ○ | ○ | ○ |
| | | Deformation condition | ○ | ○ | ○ | ○ | ○ | ○ | ○ | ○ | ○ | ○ |
| | Hydrolytic resistance (pressure cooker test) — 200 hours later | Retention of fracture stress | ○ | ○ | ○ | ○ | ○ | ○ | ○ | ○ | ○ | ○ |
| | | Retention of elongation | ○ | ○ | ○ | ○ | ○ | ○ | ○ | ○ | ○ | ○ |
| | | Deformation condition | ○ | ○ | ○ | ○ | ○ | ○ | ○ | ○ | ○ | ○ |
| | Improvement rate of conversion efficiency (%) | | 24 | 24 | 26 | 20 | 26 | 25 | 20 | 25 | 26 | 25 |
| | Weatherability | | ○ | ○ | ○ | ○ | ○ | ○ | ○ | ○ | ○ | ○ |
| | Water vapor barrier property (permeability test: $g/m^2 \cdot d$) | | 0.3 | 0.3 | 0.3 | 0.4 | 0.3 | 0.3 | 0.3 | 0.3 | 0.3 | 0.4 |
| | Scratch resistance | | ○ | ○ | ○ | ○ | ○ | ○ | ○ | ○ | ○ | ○ |
| | Flame resistance | | ○ | ○ | ○ | ○ | ○ | ○ | ○ | ○ | ○ | ○ |

INDUSTRIAL APPLICABILITY

The layered product of the present invention is high in light reflectance, excellent in heat resistance and water vapor transmittance, and further excellent in weatherability, hydrolytic resistance and flexibility. Thus, it can be utilized as a back sheet for solar cells used under severe environment exposed to sunlight, as well as a material of parts which require infrared reflectivity under severe environment at high temperature.

DESCRIPTION OF SYMBOLS

A: Layer (A), B: Layer (B), C: Layer (C), D: Layer (D), E: Layer (E), D1: Synthetic resin film, D2: Thin film layer, S: Solar battery silicon cell

**Claims**

1. A layered product which comprises a resin layer (B) as a base layer a resin layer (A) layered on one side or the resin layer (B), and a resin layer (C) layered on the other side of the resin layer (B), wherein a thickness ($H_A$) of the resin layer (A), a thickness ($H_B$) of the resin layer (B) and a thickness (He) of the resin layer (C) satisfy the following expressions (1) and (2), and a dimensional change when left at 150˚C for 30 minutes is between ±1% and a. reflectance of a light with a wavelength of 400-1400 nm is not less than 50%:

$$0.5 \leqq H_A/H_C \leqq 1.3 \quad \cdots \quad (1),$$

$$0.4 \leqq (H_A+H_C)/H_B \leqq 2.4 \quad \cdots \quad (2).$$

2. The layered product according to claim 1, wherein at least one of the resin layer (A), the resin layer (B) and the resin layer (C) contains a white pigment.

3. The layered product according to claim 1 or 2, wherein the layer (B) is made from a thermoplastic resin (I) with a glass transition temperature of not less than 120˚C, and the layer (A) and the layer (C) are made of a thermoplastic resin (II) having a glass transition temperature lower than the glass transition temperature of the thermoplastic resin (I).

4. The layered product according to claim 3, wherein the thermoplastic resin (II) is an aromatic vinyl resin (II-1) which comprises a rubber-reinforced aromatic vinyl resin (II-1-1) obtained by polymerization of a monomer (b) comprising an aromatic vinyl compound in a presence of a rubber-like polymer (a), and optionally a (co)polymer (II-1-2) of a monomer (b) comprising an aromatic vinyl compound, the content of the rubber-like polymer (a) being 5-40 parts by mass relative to 100 parts by mass of the aromatic vinyl resin (II-1).

5. The layered product according to claim 4, wherein the rubber-like polymer (a) is at least one selected from the group consisting of ethylene-α-olefin rubbers, hydrogenated conjugated diene rubbers, acrylic rubbers, silicone rubbers and sLLicone/acrylic composite rubbers.

6. The layered product according to claim 4 or 5, wherein the aromatic vinyl resin (II-1) comprises a maleimide compound unit as the monomer (b) comprising an aromatic vinyl compound, the content of the repeating units derived from the maleimide compound being 1-30 mass% relative to 100 mass% of the aromatic vinyl resin (II-1).

7. The layered product according to any one of claims 3 to 6, wherein the thermoplastic resin (I) is an aromatic vinyl resin (I-1) which comprises a rubber-reinforced aromatic vinyl resin (I-1-1) obtained by polymerization of a monomer (ii) comprising an aromatic vinyl compound in a presence of a rubber-like polymer (i) and optionally a (co)polymer (I-1-2) of a monomer (ii) comprising an aromatic vinyl compound, the content of the rubber-like polymer (i) being 5-40 parts by mass relative to 100 parts by mass of the aromatic vinyl resin (I-1).

8. The layered product according to claim 7, wherein the rubber-like polymer (i) is at least one selected from the group consisting of ethylene-cx-olefin rubbers, hydrogenated conjugated diene rubbers, acrylic rubbers, silicone rubbers and silicone/acrylic composite rubbers.

9.  The layered product according to claim 7 or 8, wherein an aromatic vinyl resin (I-1) comprises a maleimide compound as the monomer (ii) comprising an aromatic vinyl compound, the content of the repeating units derived from the maleimide compound being 1-30 mass% relative to 100 mass% of the aromatic vinyl resin (I-1).

10. The layered product according to any one claims 3 to 9, wherein the thermoplastic resin (I) has a glass transition temperature (Tg (I)) of 120-220˚C.

11. The layered product according to claim 10, wherein the thermoplastic resin (II) has a glass transition temperature (Tg (II)) satisfying the following expression (3):

$$Tg~(II) \leqq Tg~(I) - 10°C \cdots (3).$$

12. The layered product according to any one of claims 1 to 11, wherein the thickness of the layered product is 30-500 $\mu$m.

13. The layered product according to any one of claims 1 to 11, which comprises a protective layer (E) provided on the outer surface of the layer (A) or the outer surface of the layer (C).

14. The layered product according to claim 13, wherein the thickness of the layered product is 55-800 $\mu$m.

15. The layered product according to any one of claims 1 to 14, which further comprises a water vapor barrier layer (D) layered on the outer surface of the resin layer (A) or resin layer (C), between the resin layer (A) and the resin layer (B), or between the resin layer (B) and the resin layer (C).

16. The back sheet for solar cells according to claim 15, which comprises a protective layer (E) which is provided on the layer (C) side as an outermost layer.

17. The layered product according to claim 16, wherein the thickness of the layered product is 55-800 $\mu$m.

18. A back sheet for solar cells which comprises the layered product according to any one of claims 1 to 17.

19. A solar cell module which comprises the back sheet for solar cells according to claim 18.

Fig. 1

Fig. 2

Fig. 3

Fig. 4

**INTERNATIONAL SEARCH REPORT**

| International application No. |
|---|
| PCT/JP2009/059168 |

A.   CLASSIFICATION OF SUBJECT MATTER
*B32B27/30(2006.01)i, B32B25/14(2006.01)i, H01L31/04(2006.01)i*

According to International Patent Classification (IPC) or to both national classification and IPC

B.   FIELDS SEARCHED

Minimum documentation searched (classification system followed by classification symbols)
B32B1/00-43/00, H01L31/04-31/06

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2007-208179 A  (Teijin DuPont Films Japan Ltd.),<br>16 August, 2007 (16.08.07),<br>Claim 1; Par. Nos. [0003], [0006], [0011], [0015], [0017], [0027], [0036], [0051]<br>(Family: none) | 1-3,10-12, 15,18,19<br>13,14,16,17<br>4-9 |
| X<br>Y<br>A | WO 2007/007882 A1  (Teijin DuPont Films Japan Ltd.),<br>18 January, 2007 (18.01.07),<br>Claims 1, 5, 6, 7, 9, 10, 13; Par. Nos. [0001], [0004]<br>& US 2009/0034235 A1    & EP 1908587 A1<br>& KR 10-2008-0027823 A  & CN 101218098 A | 1-3,10-12, 18,19<br>13,14,16,17<br>4-9 |

[X]  Further documents are listed in the continuation of Box C.            [ ]  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 July, 2009 (07.07.09) | 21 July, 2009 (21.07.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**EP 2 279 863 A1**

**INTERNATIONAL SEARCH REPORT**

International application No.

PCT/JP2009/059168

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2007-128943 A  (Toray Industries, Inc.), 24 May, 2007 (24.05.07), Claims 1, 3; Par. Nos. [0026], [0030] (Family: none) | 13,14,16,17 |
| A | WO 2007/023865 A1  (Techno Polymer Co., Ltd.), 01 March, 2007 (01.03.07), Claims 1, 7; Par. Nos. [0105] to [0110], [0130] & US 2009/0104466 A     & EP 1918313 A1 & KR 10-2008-0039395 A   & CN 101233162 A | 4-9 |
| A | JP 11-277689 A  (Nippon Shokubai Co., Ltd.), 12 October, 1999 (12.10.99), Full text (Family: none) | 4-9 |
| A | JP 2001-294722 A  (Nippon Shokubai Co., Ltd.), 23 October, 2001 (23.10.01), Full text (Family: none) | 4-9 |
| A | JP 63-243156 A  (Japan Synthetic Rubber Co., Ltd.), 11 October, 1988 (11.10.88), Full text (Family: none) | 4-9 |
| A | JP 61-179252 A  (Mitsubishi Rayon Co., Ltd.), 11 August, 1986 (11.08.86), Full text (Family: none) | 4-9 |
| A | JP 2003-168814 A  (Dainippon Printing Co., Ltd.), 13 June, 2003 (13.06.03), Claims 1, 10, 17; Par. Nos. [0001], [0002], [0014] to [0015], [0041] & US 2006/0166023 A1     & DE 10393252 T | 1-19 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006270025 A
- JP 2007177136 A
- US 2891920 A
- US 3294725 A
- JP H04239010 A
- JP 2137934 B